# EUROPEAN PATENT APPLICATION

(11) **EP 4 756 470 A1**
(43) Date of publication of application: **10.06.2026**
(21) Application number: 24832112.7
(22) Date of filing: 28.06.2024
(51) Int. Cl.: G01R 33/20, G01N 24/00, G01R 33/032

(54) **SOLID-STATE QUANTUM SENSOR MODULE AND SENSOR DEVICE**

(30) Priority: 29.06.2023 JP 2023106764
(71) Applicant: Dai Nippon Printing Co., Ltd., Tokyo 162-8001 (JP)
(72) Inventor: OGAWA, Kenichi, Tokyo 162-8001 (JP); MIYOSHI, Toru, Tokyo 162-8001 (JP); MORIWAKI, Nobuyoshi, Tokyo 162-8001 (JP)
(74) Representative: Müller-Boré & Partner Patentanwälte PartG mbB
(86) International application number: PCT/JP2024/023524
(87) International publication number: WO 2025/005254

(57) **Abstract**

The present disclosure provides a solid-state quantum sensor module comprising: a substrate including a first main surface and a second main surface located on an opposite side to the first main surface; a solid-state element, including a color center, located on a first main surface side of the substrate; a light guide plate located between the substrate and the solid-state element; a microwave field-transmitting antenna; a light source located on the first main surface side of the substrate and emits light including a first wavelength that excites the color center from a ground state to an excited state; and a light detector located on the first main surface side of the substrate and detects photoluminescence including a second wavelength emitted from the solid-state element, wherein, when viewed along a normal direction of the first main surface of the substrate, the solid-state element overlaps with the microwave field-transmitting antenna; and when viewed along the normal direction of the first main surface of the substrate, the light detector does not overlap with the microwave field-transmitting antenna.

## Description

### Technical Field

The present disclosure relates to a solid-state quantum sensor module and a sensor device.

### Background Art

In the crystal structure of diamond, a complex defect (NV center (Nitrogen Vacancy center), including a pair of a nitrogen atom introduced into a position of a carbon atom in the crystal lattice by replacing thereof and a vacancy existing at a position adjacent to the nitrogen atom, is known. As for the crystal structure of diamond, in addition to the NV center, complex defects called, for example, a silicon-vacancy center (SiV center) and a tin-vacancy center (SnV centers) are known and these complex defects including the NV center are called color centers.

When an electron is trapped in the NV center (hereinafter referred to as "NV⁻"), the NV center forms a state called a spin triplet and behaves as a single spin. The single spin of NV⁻ changes in response to an external magnetic field, and this spin state can be measured at room temperature so that diamond including the NV center can be used as a material for, for example, a magnetic field sensor device and an electric field sensor device.

Patent document 1 discloses a sensor including an element including a color center to be excited, a pair of antennas for exciting a predetermined color center that are arranged on either side of the element, and a power supply configured to supply a variable frequency high frequency current to the pair of antennas for exciting the color center.

Also, Patent Document 2 discloses a magnetometer including a substrate; an electron spin defect layer including a plurality of lattice point defects disposed on the substrate; a microwave field transmitter; a light source; an optical resonator cavity including at least a part of the electron spin defect layer and disposed so as to recirculate the light passing through the electron spin defect layer; a light detector configured to detect photoluminescence emitted from the electron spin defect layer; and a magnet disposed adjacent to the electron spin defect layer.

### Citation List

### Patent Documents

Patent Document 1: Japanese Patent Application Laid-Open (JP-A) No. 2022-98572
Patent Document 2: JP-A No. 2022-550046

### Summary of Disclosure

### Technical Problem

A sensor device using a solid-state element including a color center includes, for example, a diamond element including an NV center; a microwave field-transmitting antenna; a light source configured to emit green light that excites the diamond element from a ground state to an excited state; and a light detector configured to observe a red fluorescence intensity. In many conventional sensor devices, the light detector is not integrated on the substrate so that there is a demand for downsizing. Meanwhile, when the light detector is integrated on a substrate for downsizing, it may be adversely affected by noise from the microwave field-transmitting antenna.

The present disclosure has been made in view of the above circumstances, and an object in the present disclosure is to provide a solid-state quantum sensor module capable of downsizing a sensor device, and reducing the impact of microwave noise on a light detector.

### Solution to Problem

One embodiment in the present disclosure provides a solid-state quantum sensor module comprising: a substrate including a first main surface and a second main surface located on an opposite side to the first main surface; a solid-state element, including a color center, located on a first main surface side of the substrate; a light guide plate located between the substrate and the solid-state element; a microwave field-transmitting antenna; a light source located on the first main surface side of the substrate and emits light including a first wavelength that excites the color center from a ground state to an excited state; and a light detector located on the first main surface side of the substrate and detects photoluminescence including a second wavelength emitted from the solid-state element, wherein when viewed along a normal direction of the first main surface of the substrate, the solid-state element overlaps with the microwave field-transmitting antenna; and when viewed along the normal direction of the first main surface of the substrate, the light detector does not overlap with the microwave field-transmitting antenna.

Another embodiment in the present disclosure provides a sensor device comprising the solid-state quantum sensor module described above.

### Advantageous Effects of Disclosure

The present disclosure is able to provide a solid-state quantum sensor module capable of downsizing a sensor device, and reducing the impact of microwave noise on a light detector.

### Brief Description of Drawings

[FIGS. 1] are a schematic top view and a schematic cross-sectional view exemplifying a solid-state quantum sensor module in the first embodiment in the present disclosure.
[FIG. 2] is a drawing showing schematic structure of a diamond element including a NV center.
[FIG. 3] is a drawing explaining the principle of a diamond quantum sensor.
[FIGS. 4} are photodetection magnetic resonance spectra obtained by a diamond quantum sensor.
[FIGS. 5] are schematic plan views exemplifying a solid-state element in the first embodiment in the present disclosure.
[FIGS. 6] are schematic plan views exemplifying a solid-state quantum sensor module in the first embodiment in the present disclosure.
[FIGS. 7] are a schematic cross-sectional view exemplifying a solid-state quantum sensor module and a schematic top view of a solid-state element in the first embodiment in the present disclosure.
[FIG. 8] is a schematic cross-sectional view exemplifying a solid-state quantum sensor module in the first embodiment in the present disclosure.
[FIGS. 9] are a schematic cross-sectional view exemplifying a solid-state quantum sensor module and a schematic top view of a solid-state element in the first embodiment in the present disclosure.
[FIG. 10] is a schematic top view exemplifying a solid-state quantum sensor module in the first embodiment in the present disclosure.
[FIGS. 11] are schematic cross-sectional views exemplifying a solid-state quantum sensor module in the first embodiment in the present disclosure.
[FIG. 12] is a schematic cross-sectional view exemplifying a solid-state quantum sensor module in the first embodiment in the present disclosure.
[FIGS. 13] are a schematic cross-sectional view and an exploded view exemplifying a solid-state quantum sensor module and schematic top views exemplifying a light guide plate and a substrate in the first embodiment in the present disclosure.
[FIGS. 14] are schematic cross-sectional views exemplifying a solid-state quantum sensor module in the first embodiment in the present disclosure.
[FIGS. 15] are a schematic top view, a schematic cross-sectional view and an exploded cross-sectional view exemplifying a solid-state quantum sensor module in the second embodiment in the present disclosure.
[FIGS. 16] are a schematic cross-sectional view exemplifying a solid-state quantum sensor module and a schematic top view of a solid-state element in the second embodiment in the present disclosure.
[FIG. 17] is a schematic cross-sectional view exemplifying a solid-state quantum sensor module in the second embodiment in the present disclosure.
[FIGS. 18] are a schematic cross-sectional view exemplifying a solid-state quantum sensor module and a schematic top view exemplifying a solid-state element in the second embodiment in the present disclosure.
[FIG. 19] is a schematic cross-sectional view exemplifying a solid-state quantum sensor module in the second embodiment in the present disclosure.
[FIGS. 20] are schematic cross-sectional views exemplifying a solid-state quantum sensor module in the second embodiment in the present disclosure.
[FIGS. 21] are a schematic top view and a schematic cross-sectional view exemplifying a sensor element structure used in the third embodiment in the present disclosure.
[FIG. 22] is a schematic cross-sectional view exemplifying a solid-state quantum sensor module in the third embodiment in the present disclosure.
[FIG. 23] is a schematic cross-sectional view exemplifying a sensor element structure in the third embodiment in the present disclosure.
[FIG. 24] is a schematic cross-sectional view exemplifying a sensor element structure in the third embodiment in the present disclosure.
[FIGS. 25] are schematic cross-sectional views exemplifying a solid-state quantum sensor module in the third embodiment in the present disclosure.
[FIG. 26] is a schematic cross-sectional view exemplifying a solid-state quantum sensor module in the third embodiment in the present disclosure.
[FIGS. 27] are a schematic cross-sectional view and an exploded cross-sectional view exemplifying a solid-state quantum sensor module and schematic top views exemplifying a light guide plate and a substrate in the third embodiment in the present disclosure.
[FIGS. 28] are a schematic cross-sectional view and an exploded cross-sectional view exemplifying a solid-state quantum sensor module in the third embodiment in the present disclosure.
[FIG. 29] is a schematic cross-sectional view exemplifying a solid-state quantum sensor module in the third embodiment in the present disclosure.

### Description of Embodiments

Embodiments in the present disclosure are hereinafter explained with reference to, for example, drawings. However, the present disclosure is enforceable in a variety of different forms, and thus should not be taken as is limited to the contents described in the embodiments exemplified as below. Also, the drawings may show the features in the present disclosure such as width, thickness, and shape of each part schematically comparing to the actual form in order to explain the present disclosure more clearly in some cases; however, it is merely an example, and thus does not limit the interpretation of the present disclosure. Also, in the present descriptions and each drawing, for the factor same as that described in the figure already explained, the same reference sign is indicated and the detailed explanation thereof may be omitted.

In the present descriptions, in expressing an aspect wherein some member is disposed on the other member, when described as merely "on" or "below", unless otherwise stated, it includes both of the following cases: a case wherein some member is disposed directly on or directly below the other member so as to be in contact with the other member, and a case wherein some member is disposed on the upper side or the lower side of the other member via yet another member. Also, in the present descriptions, on the occasion of expressing an aspect wherein some member is disposed on the surface of the other member, when described as merely "on the surface side" or "on the surface", unless otherwise stated, it includes both of the following cases: a case wherein some member is disposed directly on or directly below the other member so as to be in contact with the other member, and a case wherein some member is disposed on the upper side or the lower side of the other member via yet another member.

### A. Solid-state quantum sensor module

The inventors of the present application found out that a solid-state quantum sensor module can be downsized by integrating a light source and a light detector (photodetector) on the first main surface side of a substrate.

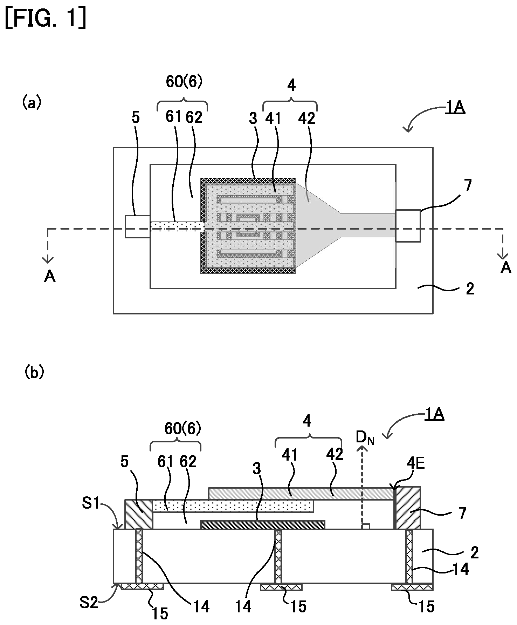

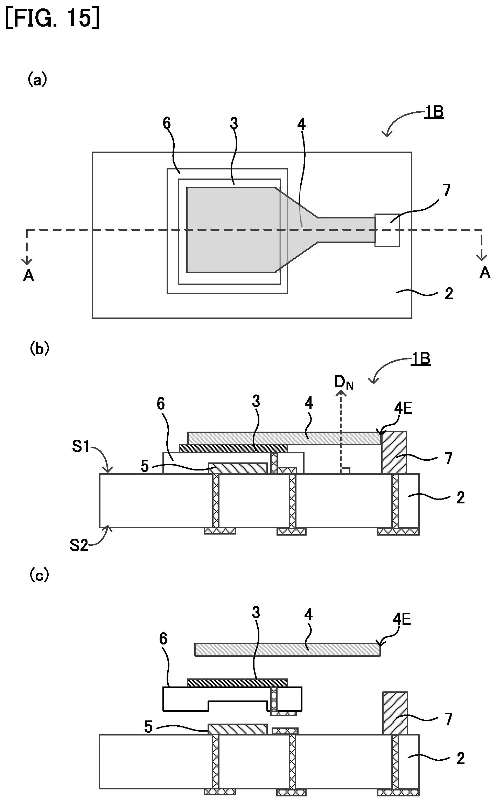

FIG. 1(a) is a schematic top view exemplifying a solid-state quantum sensor module in the first embodiment in the present disclosure, and FIG. 1(b) is an A-A line schematic cross-sectional view of FIG. 1(a). Incidentally, in FIG. 1(b), the pattern shape of the microwave field-transmitting antenna is omitted. FIG. 15(a) is a schematic top view exemplifying a solid-state quantum sensor module in the second embodiment in the present disclosure, FIG. 15(b) is an A-A line schematic cross-sectional view of FIG. 15(a), and FIG. 15(c) is an exploded cross-sectional view of FIG. 15(b).

As shown in FIG. 1(a), FIG. 1(b), and FIG. 15(a) to FIG. 15(c), in the solid-state quantum sensor modules 1A and 1B in the present disclosure, since the light source 5 and light detector 7 can be integrated onto the first main surface S1 of the substrate 2, downsizing is possible. Further, according to the present disclosure, since the light guide plate 6 located between the substrate 2 and the solid-state element 4, in the normal direction D_{N} of the first main surface S1 of the substrate 2, is included, the light including the first wavelength (excitation light) emitted from the light source 5 can be guided into the solid-state element 4 effectively. According to the solid-state quantum sensor module in the present disclosure, the impact of microwave noise on the light detector 7 can be reduced since the light detector 7 does not overlap with the microwave field-transmitting antenna 3, when viewed along the normal direction D_{N} of the first main surface S1 of the substrate 2. Further, microwave from the microwave field-transmitting antenna can be irradiated effectively to the color center, since the solid-state element 4 is located at a location overlapping with the microwave field-transmitting antenna 3, when viewed along the normal direction D_{N} of the first main surface S1 of the substrate 2. Hereafter, the normal direction D_{N} of the first main surface S1 of the substrate 2 is also simply referred to as the normal direction D_{N}.

The solid-state quantum sensor module in the present disclosure will be hereinafter described in detail, dividing thereof into the first embodiment and the second embodiment, according to the location of the light source. Also, a solid-state quantum sensor module using a sensor element structure including a solid-state element is described as the third embodiment.

### A-1. First embodiment

The solid-state quantum sensor module 1A in the first embodiment shown in FIG. 1(a) and FIG. 1(b) comprises a substrate 2 including a first main surface S1 and a second main surface S2 located on an opposite side of the first main surface S1; a solid-state element 4, including a color center, located on a first main surface S1 side of the substrate 2; a light guide plate 6 located between the substrate 2 and the solid-state element 4 in the normal direction D_{N}; a microwave field-transmitting antenna 3; a light source 5 located on the first main surface S1 side of the substrate 2 and emits light including a first wavelength that excites the color center from a ground state to an excited state; and a light detector 7 located on the first main surface S1 side of the substrate 2 and detects photoluminescence including a second wavelength emitted from the solid-state element 4. Also, when viewed along the normal direction D_{N} of the first main surface S1 of the substrate 2, the solid-state element 4 overlaps with the microwave field-transmitting antenna 3. Also, when viewed along the normal direction D_{N} of the first main surface S1 of the substrate 2, the light detector 7 does not overlap with the microwave field-transmitting antenna 3. Further, in the present embodiment, when viewed along the normal direction D_{N} of the first main surface S1 of the substrate 2, the light source 5 does not overlap with the microwave field-transmitting antenna 3.

In the solid-state quantum sensor module 1A in the present embodiment, the microwave noise on the light source 5 can be reduced and high-definition sensing is possible with the solid-state quantum sensor module, since the light source 5 does not overlap with the microwave field-transmitting antenna 3, when viewed along the normal direction D_{N}.

In the solid-state quantum sensor module 1A in the present embodiment, in a region overlapping with the light guide plate 6, when viewed along the normal direction D_{N}, the microwave field-transmitting antenna 3 is preferably located on the substrate 2 side than the light guide plate 6 in the normal direction D_{N}. In this case, the microwave field-transmitting antenna 3, the light guide plate 6 and the solid-state element 4 are arranged in this order from the substrate 2 side. By having such a stacked structure, light including the first wavelength can be introduced from the light guide plate 6 to the solid-state element 4 further efficiently. Further, by providing the microwave field-transmitting antenna 3 adjacent to the substrate 2, it is easy to connect to the through electrode layer 14 which goes though the substrate 2. Each constitution of the solid-state quantum sensor module in the present embodiment is hereinafter described in detail.

### 1. Solid-state element

As shown in FIG. 1(a) and FIG. 1(b), the solid-state element 4 including a color center in the present embodiment is located on the first main surface S1 side of the substrate 2. Further, when viewed along the normal direction D_{N} of the first main surface S1 of the substrate 2, the solid-state element 4 overlaps with the microwave field-transmitting antenna 3. The phrase "the solid-state element 4 overlaps with the microwave field-transmitting antenna 3 when viewed along the normal direction D_{N}" means that at least a part of the solid-state element 4 overlaps with the microwave field-transmitting antenna 3, when viewed along the normal direction D_{N} of the first main surface S1 of the substrate 2. Also, in the normal direction D_{N}, the solid-state element 4 is located on the surface of the light guide plate 6 that is opposite to the substrate 2 side. Also, in the normal direction D_{N}, the solid-state element 4 is preferably located on the surface of the microwave field-transmitting antenna substrate 3 that is opposite to the substrate 2 side.

As shown in FIG. 1(a) and FIG. 1(b), when viewed along the normal direction D_{N}, at least a part of the solid-state element 4 preferably overlaps with the light guide plate 6.

A solid-state element including a color center is a point defect in a solid-state ionic crystal to which an electron or a hole is supplemented. Examples of the material used for the solid-state element including a color center may include diamond and silicon carbide (SiC), and among them, diamond with excellent spin coherence properties at room temperature is preferable. Examples of the color center may include a color center of diamond and a color center of silicon carbide (SiC). Examples of the color center of diamond may include a nitrogen-vacancy center (NV center) and a silicon-vacancy center, and the NV center is preferable.

The operating mechanism of a magnetic sensor using a diamond crystal as the solid-state element and an NV center as the color center will be described in detail below.

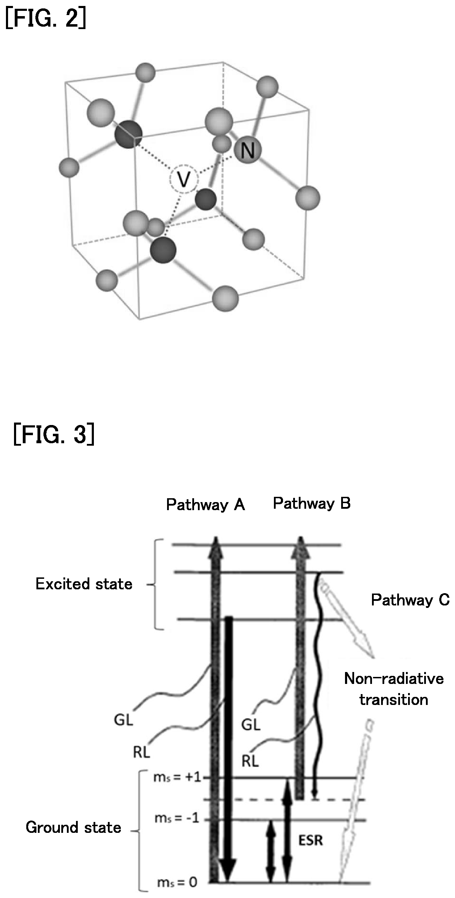

FIG. 2 is a view showing a schematic structure of a diamond element including an NV center. As shown in FIG. 2, the NV center is a complex impurity defect including a pair of nitrogen introduced into a substitutional position for the carbon in the diamond lattice and a vacancy where the carbon atom adjacent to this nitrogen fell out. When this NV center captures one electron to change the state from the neutral charge state NV⁰ to NV⁻ with a valence of -1, it forms an electron spin triplet state of magnetic quantum number mₛ = -1, 0, +1.

FIG. 3 is a view for explaining the principle of a diamond quantum sensor including a diamond element including NV⁻ and that measures, for example, magnetic field intensity based on the principle of photodetection magnetic resonance. When green light GL (wavelength of approximately 532 nm) is irradiated onto the diamond element without active microwave irradiation, electrons excited from the state of mₛ = 0 are relaxed to be the original state of mₛ = 0 (pathway A) by emitting red fluorescence RL of a longer wavelength (approximately 637 nm).

Meanwhile, when microwaves of around 2.87 GHz are irradiated onto this crystal, electrons can be excited from the state of mₛ = 0 to the state of mₛ = ± 1 due to electron spin resonance. When the green light is irradiated to the state of mₛ = ± 1, a part of the electrons emits red fluorescence (pathway B), while a part of the electrons relaxes to the state of mₛ = 0 via non-radiative transition (pathway C), and therefore do not contribute to the emission of light. Therefore, when the electron of the NV center is excited from the level at which electron spin resonance occurs, the luminance of the red fluorescence RL decreases.

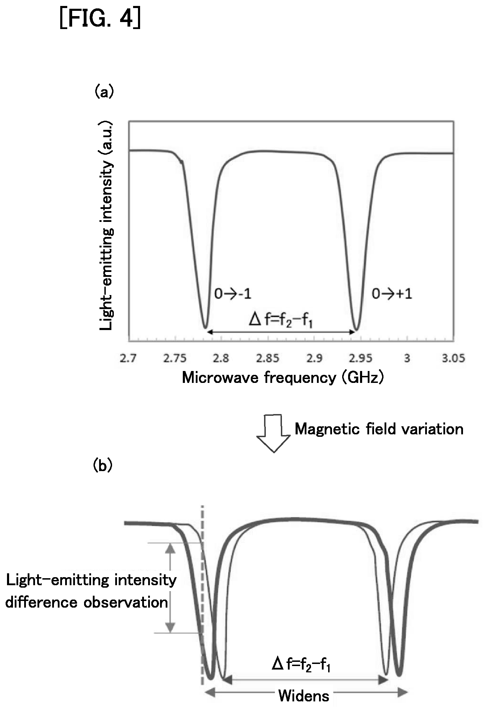

Although the state of mₛ = ± 1 is degenerated under a non-magnetic field, a Zeeman splitting occurs under a magnetic field so as to split into two levels. Taking advantage of this property, the resonance level can be accurately measured by sweeping the microwave that excites the electron from the state of mₛ = 0 to the state of mₛ = ± 1 due to electron spin resonance (ESR). As shown in FIG. 4(a) for example, when a magnetic field is applied to NV⁻, an photodetection magnetic resonance spectrum, in which there are two points where the luminance of the red fluorescence RL drops, is obtained. When mₛ = ± 1 widens due to the influence of an external magnetic field, the energy difference between the two peaks (here, the frequency difference Δf = f₂ - f₁) also widens (FIG. 4(b)). In this way, the split Δf (= f₂ - f₁) of the frequency of the microwave MW corresponding to the two luminance drop points increases in proportion to the external magnetic field. Therefore, the external magnetic field can be measured from the red emission intensity.

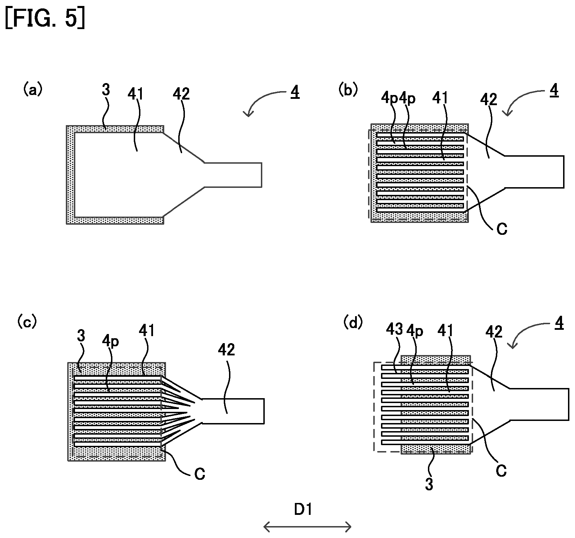

FIG. 5(a), FIG. 5(b), FIG. 5(c), and FIG. 5(d) are schematic plan views exemplifying a solid-state element in the present embodiment, and they also show microwave field-transmitting antennas 3. As shown in FIG. 5(a), FIG. 5(b) and FIG. 5(c), the solid-state element 4 preferably includes the light-emitting region (luminescent region) 41 and the connecting region 42, which is the region between the light-emitting region 41 and the light detector. Also, as shown in FIG. 5(d), the solid-state element 4 may include other regions 43 other than the light-emitting region 41 and the connecting region 42. When viewed along the normal direction D_{N}, the light-emitting region 41 is a region that overlaps with the region of the microwave field-transmitting antenna 3. Incidentally, when the conductive pattern such as a loop antenna formed in a planar shape which will be described later is included, the region of the microwave field-transmitting antenna 3 refers to a region including the conductive pattern.

As shown in FIG. 5(a), the solid-state element in the present embodiment may be in the form of a flat plate. In this case, it is preferably a flat plate extending in the direction D1, from the light source 5 toward the light detector 7. Also, as shown in FIG. 5(b), FIG. 5(c) and FIG. 5(d), the solid-state element 4 preferably includes one or more line patterns 4p extending in the direction D1, from the light source 5 toward the light detector 7. In particular, the solid-state element 4 preferably includes a plurality of line patterns 4p. Hereinafter, the structure of each line pattern 4p of the solid-state element 4 in the present embodiment is also referred to as a first photonic cavity structure. In particular, it is preferable that the light-emitting region 41 in the solid-state element has the first photonic cavity structure. By including such a first photonic cavity structure, photoluminescence including the second wavelength can be efficiently supplied to the light detector side, due to the refractive index difference with respect to air. Furthermore, by combining the solid-state element 4 including the first photonic cavity structure with the light guide plate 6, light can be efficiently introduced and extracted in the horizontal direction, and when viewed along the normal direction D_{N}, the light source 5 and the light detector 7 can be disposed at a distance away from the microwave field-transmitting antenna 3.

As shown in FIG. 5(b), FIG. 5(c) and FIG. 5(d), the solid-state element 4 preferably includes a pattern group C including a plurality of the line patterns 4p.

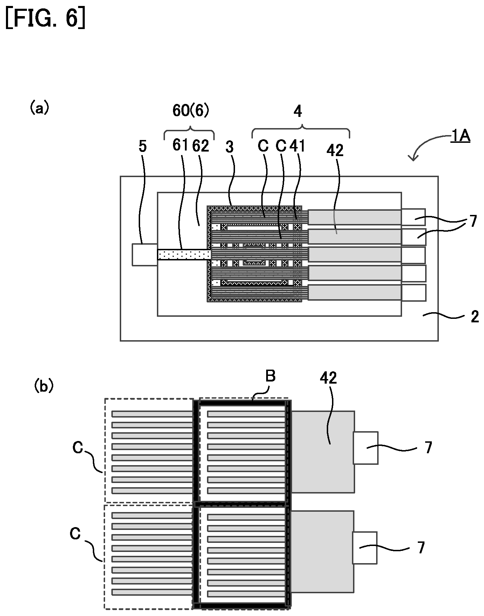

FIG. 6(a) and FIG. 6(b) are schematic plan views exemplifying a solid-state quantum sensor module in the present embodiment. As shown in FIG. 6(a), the solid-state element 4 in the present embodiment may include a plurality of the pattern groups C. In this case, as shown in FIG. 6(a), the solid-state element 4 may a plurality of connecting regions 42 connected to each pattern group C, and the solid-state quantum sensor module 1A may include a plurality of light detectors 7.

Since each pattern group C shown in FIG. 6(a) includes a plurality of line patterns 4p, it may be difficult to recover photoluminescence when a defect occurs in the producing process. As shown in FIG. 6(b), the solid-state element 4 in the present embodiment may be divided into a plurality of independent pattern groups C, by bath cavities B. When the solid-state element 4 includes such a bus cavity B, the recovery loss of photoluminescence due to line pattern defects can be reduced.

One or more of the above line patterns (first photonic cavity structure) and bus cavities can be formed by conventionally known methods, and they can be formed by, for example, by etching a flat solid-state element (diamond).

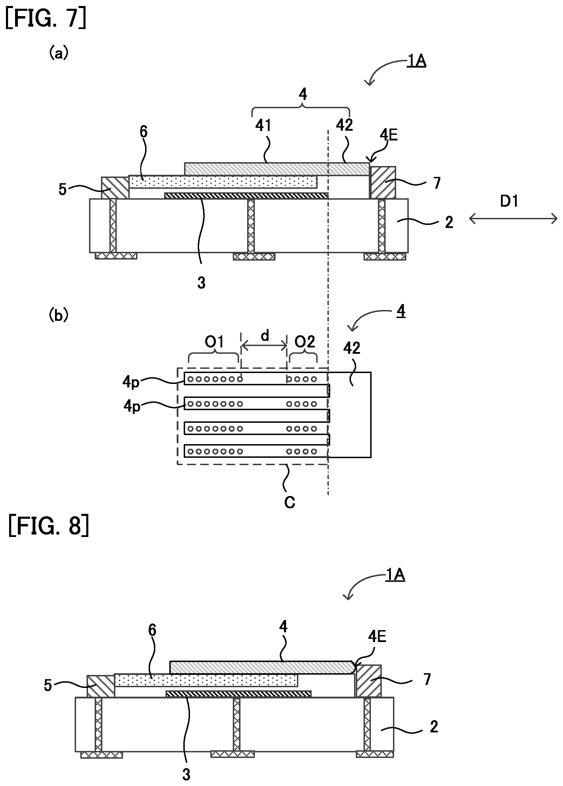

FIG. 7(a) is a schematic cross-sectional view exemplifying a solid-state quantum sensor module in the present embodiment. FIG. 7(b) is a schematic top view of the solid-state element 4 in FIG. 7(a). As shown in FIG 7(a) and FIG. 7(b), in the solid-state element 4 in the present embodiment, each line pattern 4p preferably has a photonic mirror structure. The photonic mirror structure allows the increase of the intensity of photoluminescence including the second wavelength, enabling highly sensitive sensing. The photonic mirror structure is not particularly limited as long as it is a structure capable of amplifying light by controlling its transmission and reflection through a structure with a plurality of periodically arranged dielectric materials, thereby confining and resonating the light, and examples are disclosed in the Handbook of Quantum Interactions of Light and Matter (NTS Co., Ltd.) and Introduction to Photonic Crystals (Morikita Publishing Co., Ltd.).

As a specific example, as shown in FIG. 7(b), it is preferable to arrange an air gap group O1 including n1 air gaps ("n1" is an integer of 5 or more) positioned periodically on the light source 5 side of the solid-state element 4 (line pattern 4p) in the D1 direction; and to arrange an air gap group O2 including n2 air gaps ("n2" is an integer of 2 or more and less than "n1") positioned periodically also on the light detector 7 side of the line pattern 4p of the solid-state element 4 in the D1 direction. By arranging the air gaps in this manner, the air gap group O1 on the light source side and the air gap group O2 on the light detector side reflect the light including the second wavelength, and the light can be resonated and amplified in an interspace between the air gap groups d. Also, by making the number of air gaps n2 in the air gap group on the light detector side of the solid-state element less than the number of air gaps n1 in the air gap group on the light source side of the solid-state element, the air gap group on the light detector side can function like a semi-transparent mirror, making it easier for light to travel toward the light detector. The air gap group O1 and the air gap group O2 are preferably formed so that at least the interspace between the air gap groups d is located in the light-emitting region 41. The air gap group O1 and the air gap group O2 may be formed in the light-emitting region 41. The air gap group O2 may be formed in the connecting region 42. The air gap group O1 may be formed in a region other than the light-emitting region 41 and the connecting region 42 (region 43 in FIG. 5(d)).

Such optical path length of the interspace between the air gap groups d is preferably, for example, n3-fold ("n3" is an integer) of (the second wavelength λ₂/2). This is because the resonance of the light including the second wavelength tends to occur. Incidentally, the optical path length is a value obtained by multiplying the physical distance by the refractive index of the medium.

The distance between the air gaps in the air gap group and the air gap size are appropriately set to equal to or less than the optical distance of half-wavelength of the light to be controlled (second wavelength λ₂/2) by, for example, simulation based on the controlled light wavelength (second wavelength λ₂) and physical properties such as the dielectric constant and transmittance of the photonic cavity material (that is, the solid-state element material).

The air gap can be formed, for example, by stacking a metal layer on a solid-state element (for example, diamond), and carrying out dry etching such as oxygen plasma, using the metal pattern obtained by patterning the metal layer as a mask. The metal pattern stacked as a mask may be removed by, for example, wet etching after forming the air gaps.

FIG. 8 is a schematic cross-sectional view exemplifying a solid-state quantum sensor module in the present embodiment. As shown in FIG 8, the solid-state element 4 in the present embodiment preferably has a curvature on the light detector side end portion 4E. Here, "the light detector side end portion has a curvature" means that the light detector side end portion 4E is curved in a convex shape to the light detector side in a perpendicular direction to the normal direction. This is because the light emitted from the solid-state element can be converted to the convergent light by a convex lens, making it easier to introduce the light including the second wavelength into the light detector 7.

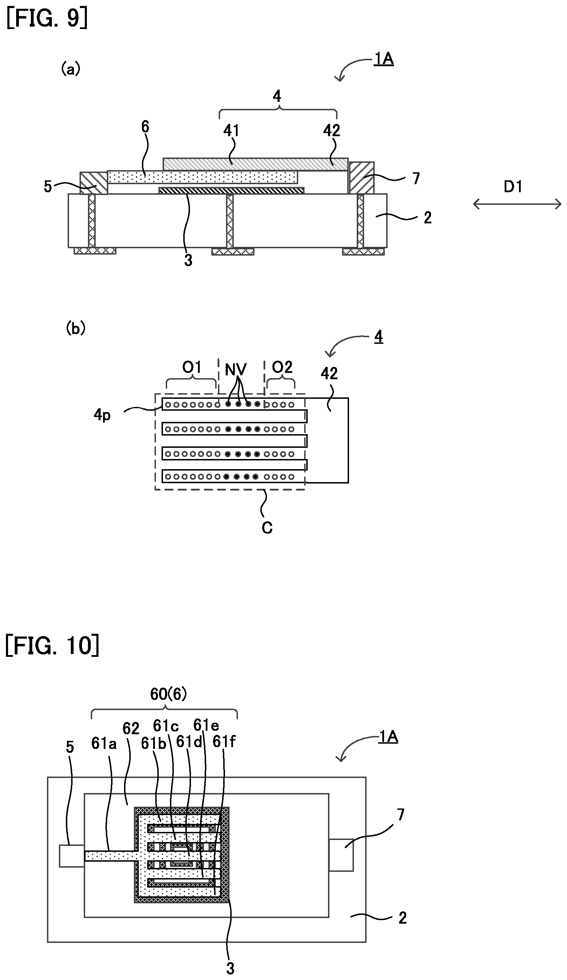

FIG. 9(a) is a schematic cross-sectional view exemplifying a solid-state quantum sensor module in the present embodiment. FIG. 9(b) is a schematic top view of the solid-state element in FIG. 9(a). As shown in FIGS. 9, the solid-state element 4 in the present embodiment preferably includes a plurality of color centers (NV in FIGS. 9) located side by side at a predetermined distance along the direction D1 toward the light detector. Also, each line pattern 4p in the solid-state element 4 preferably includes a plurality of color centers (NV) located side by side at a predetermined distance. By including the plurality of the color centers located side by side at a predetermined distance, the light including the second wavelength can be suppressed from offsetting with each other, and the light emitting amount can be amplified. The predetermined distance (optical path length) is preferably n4-fold of the second wavelength λ₂. The "n4" described above is preferably 0.6 or more and 1.4 or less, and more preferably 0.8 or more and 1.2 or less. The plurality of the color centers located side by side at a predetermined distance are preferably disposed in the light-emitting region 41. The plurality of the color centers located side by side at a predetermined distance may be disposed in the connecting region 42. As shown in FIGS. 9, the plurality of the color centers located side by side at a predetermined distance are preferably disposed between the air gap group O1 and air gap group O2 described above.

As for the method for disposing the color centers at the predetermined distance, conventional commonly known methods can be used. To artificially form an NV center in a diamond, for example, a vacancy is introduced into the diamond, at the same time as a nitrogen atom. As a method for introducing a nitrogen atom, the following method is used: after preparing a diamond, an ion implantation method is used. In the ion implantation method, nitrogen atoms can be introduced into the diamond at the desired position and the desired amount by improving the focusing technique of the ion beam and the control of the ion amount. In the ion implantation method, ions accelerated to several tens to several thousands of kV are usually irradiated, and therefore vacancies are also introduced at the same time as nitrogen. Alternatively, a method is used in which electron beams are irradiated, in a controlled manner, to a diamond pre-doped with nitrogen by introducing nitrogen during diamond synthesis.

In the present embodiment, the thickness of the solid-state element is not particularly limited, and is 50 nm or more, may be 100 nm or more, and may be 150 nm or more. Meanwhile, the thickness is, for example, 1000 µm or less, may be 100 µm or less, and may be 1 µm or less.

### 2. Microwave field-transmitting antenna

The solid-state quantum sensor module in the present embodiment includes a microwave field-transmitting antenna to apply a microwave field to the solid-state element. As shown in FIG. 1(b), when viewed along the normal direction D_{N}, the microwave field-transmitting antenna 3 is disposed at a location overlapping with at least a part of the solid-state element 4. Further, in the normal direction D_{N}, the microwave field-transmitting antenna 3 is preferably located on the substrate 2 side than the solid-state element 4. In the present embodiment, the microwave field-transmitting antenna 3 may be located on the surface of the substrate 2, may be located in the substrate 2, and may be located between the substrate 2 and light guide plate 6. The microwave field-transmitting antenna 3 includes, for example, a metal layer. The material of the metal layer is not particularly limited as long as it has excellent conductivity, and examples thereof may include metals such as gold, silver, copper, iron, nickel, and chromium; and alloys. The metal layer may have a patterned shape. The shape of the metal layer of the microwave field-transmitting antenna 3 in the present embodiment may include loop shapes, patch shapes referred to as microstrip antenna, and stripe shapes. Also, for the microwave field-transmitting antenna in the present embodiment, the transparent antenna (transmissive antenna) described in the second embodiment in detail can also be used.

In the present embodiment, the shape is preferably a metal layer shape that transmits microwaves mainly in vertical direction so that the light detector and light source are not directly exposed to microwaves. Examples of such shape may include loop antennas and microstrip antennas formed in a planar shape.

The solid-state quantum sensor module in the present embodiment may include a microwave field control circuit that supplies the microwave source signal to the microwave field-transmitting antenna. The microwave field control circuit may be electrically connected to the microwave field-transmitting antenna. The microwave frequency of the microwave source signal is, for example, approximately 2 GHz or more and approximately 4 GHz or less.

### 3. Light source

The solid-state quantum sensor module in the present embodiment includes a light source located on the first main surface side of the substrate and emits light including a first wavelength that excites the color center in the solid-state element from a ground state to an excited state. As shown in FIG. 1(a) and FIG. 1(b), in the present embodiment, the light source 5 is disposed at a location capable of emitting the light including the first wavelength toward the in-plain direction of the light guide plate 6 and that does not overlap with the microwave field-transmitting antenna 3 when viewed along the normal direction D_{N}.

The light emitted from the light source includes the first wavelength that excites one or more color centers in the solid-state element from a ground state to an excited state. The first wavelength is different from the second wavelength emitted by the color center described later. The first wavelength may be, for example, approximately 532 nm, to excite the color center in the solid-state element.

Examples of the light source may include light emitting diodes and lasers.

### 4. Light guide plate

The solid-state quantum sensor module in the present embodiment is provided with a light guide plate located between the substrate and the solid-state element, and configured to guide the light including the first wavelength emitted from the light source to the solid-state element. In the present embodiment, the light guide plate may be an optical waveguide that propagates light in the surface direction of the light guide plate, and may be a diffuser plate that diffuses light in the vertical direction.

### (1) Optical waveguide

As shown in FIG. 1(a) and FIG. 1(b), in the present embodiment, the light guide plate 6 is preferably an optical waveguide 60 including a core layer 61 and a clad layer 62 having a refractive index different from that of the core layer 61. The clad layer may include a first clad layer including a concave portion for the core layer, and a second clad layer that seals the core layer disposed in the concave portion of the first clad layer. The refractive index of the clad layer is preferably lower than that of the core layer, and light that enters the core layer is transmitted inward while being totally reflected at the boundary with the clad layer.

Both the core layer and the clad layer preferably include a cured product of a curable resin composition that is cured by heat or light. Examples of the cured product of a curable resin composition may include cured products of ionizing radiation curable resin compositions and cured products of thermosetting resin compositions. Examples of the ionizing radiation curable resin composition may include ultraviolet curable resin compositions, and electron beam curable resin compositions. Examples of materials for the ultraviolet curable resin composition may include polymerizable oligomers or monomers including an acryloyl group such as urethane acrylate, oligoester acrylate, trimethylolpropane triacrylate, neopentyl glycol diacrylate, epoxy acrylate, polyester acrylate, polyether acrylate, and melamine acrylate; or blends of these oligomers or monomers with monofunctional or polyfunctional monomers including a polymerizable vinyl group such as acrylic acid, acrylamide, acrylonitrile, and styrene, to which a photopolymerization initiator, sensitizer, or desired additives have been added.

The optical waveguide may include a resin substrate configured to support the core layer and clad layer. The resin substrate film is formed from, for example, polyethylene terephthalate (PET), or polycarbonate (PC). Incidentally, the resin substrate is necessary in the production stage of the optical waveguide, and may be removed when it is actually used.

FIG. 10 is a schematic top view of a solid-state quantum sensor module in the present embodiment. In FIG. 10, the solid-state element 4 is omitted. As shown in FIG. 10, the core layer 61 preferably includes one linear main core portion 61a and a branched structure which branches into two or more branched core portions (61b, 61c, 61d, 61e, 61f) at a branch portion located midway. The branch core sections are arranged at predetermined intervals, and the clad layer 62 preferably encloses the five branch core sections together.

The optical waveguide preferably includes the branched core portion in the region that overlaps the light-emitting region of the solid-state element described above. This is because light of the first wavelength can be efficiently introduced into solid-state element.

### (2) Diffuser plate

The diffuser plate is not particularly limited as long as it is one that is generally used as a diffuser plate, and for example, those made from methacrylate styrene copolymer, methylmethacrylate styrene copolymer, acrylonitrile-styrene copolymer, polycarbonate (PC), polyethylene terephthalate (PET), and polystyrene can be used.

Also, the diffuser plate used in the present invention may include particles. Examples thereof may include inorganic based particles such as silica and alumina; acrylic resins; styrene resins; fluorine resin particles such as polytetrafluoroethylene and polyfluorobinylidene; and silicone resin particles. One type of these particles may be used alone, and two types or more may be used in a combination. From the viewpoint of diffusability, the average particle size of the particles is preferably in a range of 0.8 µm or more and 10 µm or less. The content of the particles can be adjusted accordingly.

### (3) Others

The light guide plate in the present embodiment may have both functions of the optical waveguide and diffuser plate described above. For example, when viewed along the normal direction D_{N}, the light including the first wavelength is propagated by the optical waveguide, from the light source to the light source side end portion of the light-emitting region of the solid-state element, and the diffuser plate is used in the region overlapping with the light-emitting region, making it easier to introduce light into the solid-state element located above.

### 5. Light detector

The solid-state quantum sensor module in the present embodiment is provided with a light detector located on the first main surface side of the substrate and detects photoluminescence including the second wavelength emitted from the solid-state element. The photoluminescence may include, as the second wavelength, one or more wavelengths of light corresponding to the emission wavelength of the color center (for example, wavelength of approximately 637 nm).

As shown in FIG. 1(b), the light detector 7 is preferably disposed so that the detection surface of the light detector 7 faces the end portion 4E of the solid-state element 4. Also, the light detector 7 and the solid-state element 4 may be in direct contact with each other.

### 6. Substrate

The solid-state quantum sensor module in the present embodiment includes a substrate. The substrate is a member configured to support components such as the light source, light detector, solid-state element, light guide plate, and microwave field-transmitting antenna described above.

The material of the substrate may be, for example, organic materials, may be inorganic materials, and may be composite materials including an organic material and an inorganic material. Among them, in the present embodiment, the substrate is preferably material including inorganic material, and particularly preferably inorganic material.

For, for example, the inorganic material substrate, examples of the material of the substrate may include substrates formed from inorganic materials such as glass substrates, ceramic substrates, resin substrates, silicon substrates, quartz substrates, and sapphire substrates. In the present embodiment, the substrate is preferably a glass substrate or a silicon substrate. When the substrate is a glass substrate, examples of the glass used may include soda-lime glass, alkaline-free glass, and quartz glass. Also, when the substrate is a resin substrate, examples of the resin used may include polyimide. Also, when the substrate is a composite material substrate, examples thereof may include glass-epoxy substrates.

As shown in FIG. 1(b), the substrate 2 may include a through hole penetrating in the normal direction D_{N}. A through electrode layer 14 is disposed on the inner wall of the through hole. Also, a conductive layer 15 may be provided on the second main surface S2 side of the substrate 2, and for example, in the substrate 2, the light source 5, the light detector 7, and the microwave field-transmitting antenna 3 may be electrically connected to the conductive layer 15 by the through electrode layer 14 formed within the through hole of the substrate 2.

The materials for the through electrode layer and the conductive layer are not particularly limited as long as they are conductive, and examples thereof may include metal materials such as simple metals, alloys, and metal compounds. Examples of metal elements included in the metal material may include chromium, manganese, iron, cobalt, nickel, copper, zinc, gallium, germanium, arsenicum, ruthenium, rhodium, palladium, silver, cadmium, indium, tin, antimony, osmium, iridium, platinum, gold, mercury, thallium, lead, bismuth, molybdenum, titanium, tungsten, tantalum, and aluminum. Among these, simple metals such as copper, gold, silver, platinum, rhodium, tin, aluminum, nickel, and chromium, or alloys including at least one type of these metal elements, are preferable.

### 7. Others

### (1) Reflective layer

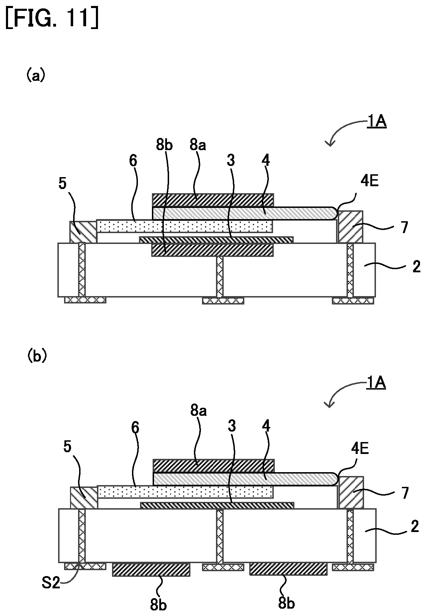

FIG. 11(a) and FIG. 11(b) are schematic cross-sectional views exemplifying a solid-state quantum sensor module in the present embodiment. As shown in FIG. 11(a), the solid-state quantum sensor module 1A in the present embodiment preferably includes a first reflective layer 8a, configured to reflect light including the first wavelength, on the surface of the solid-state element 4 that is opposite to the surface on the light guide plate 6 side. Further, a second reflective layer 8b, configured to reflects the light including the first wavelength, is preferably provided on the surface of the microwave field-transmitting antenna 3 that is opposite to the surface on the light guide plate 6 side. In particular, when the light guide plate 6 is the diffuser plate described above, it is preferable to provide the first reflective layer 8a and the second reflective layer 8b. When the substrate 2 is a glass substrate, the second reflective layer 8b may be located on the second main surface S2 side of the substrate 2, as shown in FIG. 11(b). By providing such a reflective layer, the light including the first wavelength can be suppressed from leaking out without being introduced into the solid-state element.

The reflective layer is not particularly limited as long as it is a layer capable of reflecting the light including the first wavelength, and examples thereof may include metal vapor deposition films. The thickness of the reflective layer is not particularly limited as long as it is a thickness capable of obtaining a desired reflectance with respect to the light including the first wavelength may be obtained, and is appropriately set.

### (2) First wavelength selective filter and second light wavelength selective filter

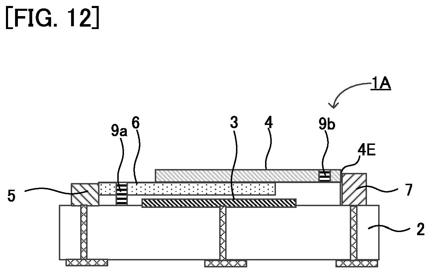

FIG. 12 is a schematic cross-sectional view exemplifying a solid-state quantum sensor module in the present embodiment. As shown in FIG. 12, the solid-state quantum sensor module 1A in the present embodiment is preferably provided with a first light wavelength selective filter 9a, that selectively transmits the light including the first wavelength, in the light guide plate 6. Light of undesired wavelengths other than the light including the first wavelength can be suppressed, and sensing can be made more efficient and sensitive. The first light wavelength selective filter may be located between the light guide plate 6 and the light source 5.

As shown in FIG. 12, the solid-state quantum sensor module 1A in the present embodiment is preferably provided with a second light wavelength selective filter 9b, that selectively transmits the light including the second wavelength, in the solid-state element 4. Light of undesired wavelengths other than the light including the second wavelength can be suppressed, and sensing can be made more efficient and sensitive. The second light wavelength selective filter may be located between the solid-state element 4 and the light detector 7.

The first light wavelength selective filter and second light wavelength selective filter are not particularly limited as long as they selectively transmits the light of the first wavelength and light of the second wavelength respectively, and a well-known filter can be used. For example, the first light wavelength selective filter is configured to transmit light including the first wavelength (for example, green light) and reflect light other than the light including the first wavelength; and the second light wavelength selective filter is configured to transmit light including the second wavelength (for example, red light) and reflect light other than the light including the second wavelength. The first light wavelength selective filter and the second light wavelength selective filter include, for example, a multilayer film. To selectively transmit means that the transmittance of light in a specific wavelength range including the target wavelength is higher than the transmittance of light out of the specific wavelength range. The first light wavelength selective filter preferably has a transmittance of 70% or more, and more preferably 80% or more, in a wavelength band of ±50 nm around the first wavelength. The second light wavelength selective filter preferably has a transmittance of 70% or more, and more preferably 80% or more, in a wavelength band of ±50 nm around the second wavelength.

### (3) Shielding portion

The solid-state quantum sensor module in the present embodiment preferably includes a shielding portion that shields microwaves emitted from the microwave field-transmitting antenna. The shielding portion is preferably located so that it surrounds the microwave field-transmitting antenna. The shielding portion is preferably located in at least one of the substrate and the light guide plate. By providing the shielding portion, it is possible to prevent the electronic components such as the light detector and the light source from being directly exposed to the microwave noise emitted from the microwave field-transmitting antenna.

The shielding portion includes, for example, metal material. The metal material has only to be able to shield microwaves, and for example, metal materials such as aluminum, chromium, copper, silver, titanium, and gold can be used.

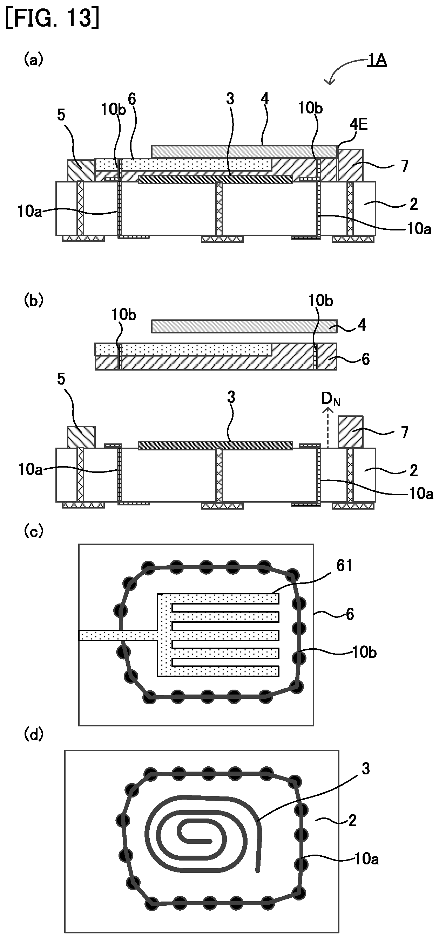

FIG. 13(a) is a schematic cross-sectional view exemplifying a solid-state quantum sensor module of the present embodiment. FIG. 13(b) is an exploded view of the solid-state quantum sensor module shown in FIG. 13(a). FIG. 13(c) is a top view of the light guide plate 6 shown in FIG. 13(b), and FIG. 13(d) is a top view of the substrate 2 and antenna 3 shown in FIG. 13(b) when viewed along the normal direction D_{N}.

The solid-state quantum sensor module shown in FIG. 13(a) to FIG. 13(d) includes the first shielding portion 10a in the substrate 2 and includes the second shielding portion 10b in light guide plate 6. In this way, the shielding effect can be improved by providing the shielding portions both in the substrate and in the light guide plate.

### (4) Photonic wire bonding

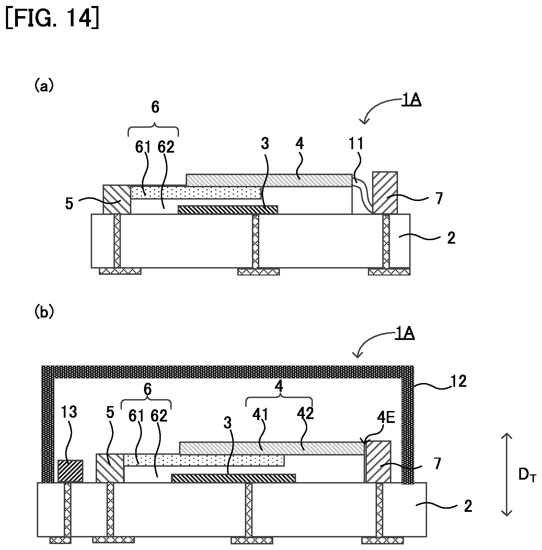

FIG. 14(a) is a schematic cross-sectional view exemplifying a solid-state quantum sensor module in the present embodiment. As shown in FIG. 14(a), in the present embodiment, the light detector 7 and the solid-state element 4 may be connected by a polymer waveguide 11 (photonic wire bonding, PWB). Since it can be produced by, for example, a 3D printer, to match the actual location of the components, the shape of the polymer waveguide is preferable for not requiring high precision alignment of the optical components to be connected. As the material for the polymer waveguide, conventionally known materials can be used.

### (5) Light shielding wall

FIG. 14(b) is a schematic cross-sectional view exemplifying a solid-state quantum sensor module in the present embodiment. As shown in FIG. 14(b), the solid-state quantum sensor module 1A preferably includes a light shielding wall 12 configured to shield extraneous light. By providing the light shielding wall, highly sensitive sensing is possible. The material of the light shielding wall is preferably a non-magnetic material having light shielding properties. A non-magnetic material is a material that is difficult to be magnetized. Examples of such materials may include metal materials such as aluminum, copper, and stainless steel, as well as carbon and chromium oxide.

### (6) Reference Light detector

The solid-state quantum sensor module in the present embodiment preferably includes a reference light detector configured to detect the light including the first wavelength. By providing a reference light detector, it becomes possible to measure the intensity of light including the first wavelength from the light source while controlling it to a constant level, thereby enabling highly sensitive sensing.

### (7) Heater element

As shown in FIG. 14(b), the solid-state quantum sensor module 1A in the present embodiment preferably includes a heater element 13 at a location surrounded by the light shielding wall 12 and substrate 2. The heater element 13 is preferably located on the first main surface side of the substrate 2. By controlling the temperature environment inside the light shielding wall 12 to a constant value using the heater element 13, it is possible to suppress a shift in the photodetection magnetic resonance spectrum due to the temperature environment, thereby enabling highly sensitive sensing.

### (8) Permanent magnet

The solid-state quantum sensor module in the present embodiment may include a permanent magnet. The permanent magnet may be located adjacent to the solid-state element. The permanent magnet is provided to induce the Zeeman effect and break the degeneracy of the mₛ = ± 1 spin sublevel.

### (9) Other members

The solid-state quantum sensor module in the present embodiment may include various electronic components such as an IC (integrated circuit), for example, an amplifier and an A/D converter.

### A-2. Second embodiment

The solid-state quantum sensor module 1B in the second embodiment shown in FIG. 15(a), FIG. 15(b), and FIG. 15(c) comprises a substrate 2 including a first main surface S1 and a second main surface S2 located on an opposite side of the first main surface S1; a solid-state element 4, including a color center, located on the first main surface S1 side of the substrate 2; a light guide plate 6 located between the substrate 2 and the solid-state element 4 in the normal direction D_{N}; a microwave field-transmitting antenna 3; a light source 5 located on the first main surface S1 side of the substrate and emits light including a first wavelength that excites the color center from a ground state to an excited state; and a light detector 7 located on the first main surface S1 side of the substrate and detects photoluminescence including a second wavelength emitted from the solid-state element 4. Also, when viewed along a normal direction D_{N} of the first main surface S1 of the substrate 2, the solid-state element 4 overlaps with the microwave field-transmitting antenna 3. Also, when viewed along the normal direction D_{N} of the first main surface S1 of the substrate 2, the light detector 7 does not overlap with the microwave field-transmitting antenna 3. Further, in the present embodiment, the microwave field-transmitting antenna 3 is a transparent antenna capable of penetrating the light including the first wavelength; when viewed along the normal direction D_{N} of the first main surface S1 of the substrate 2, the light source 5 overlaps with the microwave field-transmitting antenna 3; and in a region where the light source 5 and the microwave field-transmitting antenna 3 overlap with each other and in the normal direction D_{N}, the light guide plate 6 is located between the light source 5 and the microwave field-transmitting antenna 3.

According to the present embodiment, since the light source, light guide plate, and microwave field-transmitting antenna are disposed on top of each other, the solid-state quantum sensor module can be further downsized. Further, since the light emitted from the light source propagates in the thickness direction, the light from the light source can be efficiently introduced into the solid-state element.

Also, in the region where the light source 5 and the microwave field-transmitting antenna 3 overlap with each other, the solid-state quantum sensor module 1B in the second embodiment preferably includes the light source 5, the light guide plate 6, the microwave field-transmitting antenna 3 and the solid-state element 4 in this order from the substrate 2 side. Thereby, microwaves can be irradiated from the microwave field-transmitting antenna to the color center further efficiently. Each constitution of the solid-state quantum sensor module in the present embodiment is hereinafter described in detail.

### 1. Solid-state element

As shown in FIG. 15(a), FIG. 15(b), and FIG. 15(c), the solid-state element 4 in the present embodiment is located on the first main surface S1 side of the substrate 2, and it is located on the surface of the light guide plate 6 that is opposite side to the substrate 2 side. Also, in the normal direction D_{N}, the solid-state element 4 is preferably located on the surface of the microwave field-transmitting antenna substrate 3 that is opposite to the substrate 2 side. Also, in the normal direction D_{N}, the solid-state element 4 is located on the surface of the light source 5 that is opposite side to the substrate 2 side. In the region where the light source 5 and the microwave field-transmitting antenna 3 overlap with each other when viewed along the normal direction D_{N}, the solid-state quantum sensor module 1B in the present embodiment preferably includes the substrate 2, the light source 5, the light guide plate 6, the microwave field-transmitting antenna 3 and the solid-state element 4 in this order, in the normal direction D_{N}.

The features such as material and shape of the solid-state element in the present embodiment are similar to the solid-state element in the first embodiment.

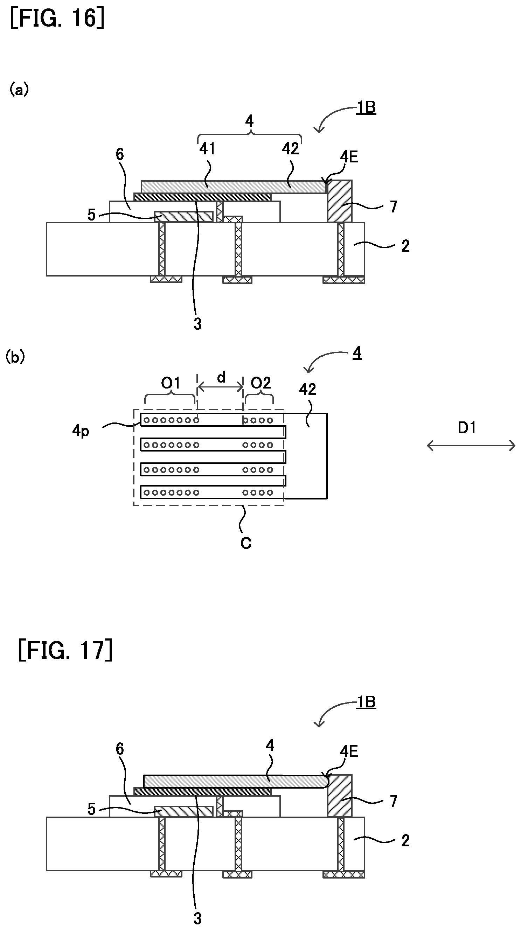

As shown in FIG. 16(a) and FIG. 16(b) for example, in the solid-state element 4 in the present embodiment, each line pattern 4p in the line pattern preferably has a photonic mirror structure.

As shown in FIG 17, the solid-state element 4 in the present embodiment preferably has a curvature on the light detector side end portion 4E.

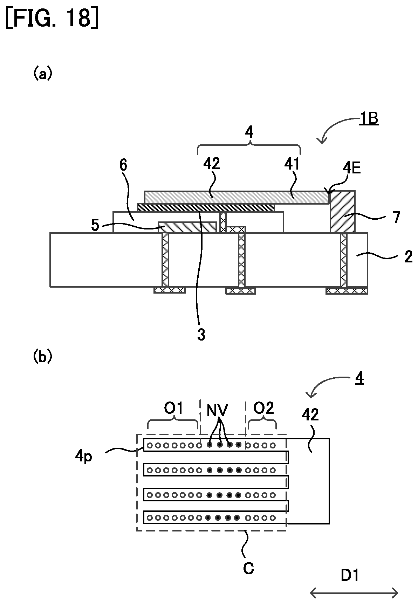

As shown in FIG. 18(a) and FIG. 18(b), the solid-state element 4 in the present embodiment preferably includes a plurality of color centers (NV in FIGS. 18) located side by side at a predetermined distance along the direction D1 toward the light detector. Also, along a direction D1 toward the light detector, each line pattern 4p in the solid-state element 4 preferably includes a plurality of color centers (NV in FIGS. 18) located side by side at a predetermined distance.

### 2. Microwave field-transmitting antenna

The solid-state quantum sensor module in the present embodiment includes a microwave field-transmitting antenna to apply a microwave field to the solid-state element. As shown in FIGS. 15, in the normal direction D_{N}, the microwave field-transmitting antenna 3 in the present embodiment is preferably located on the substrate 2 side than the solid-state element 4. In the present embodiment, the microwave field-transmitting antenna 3 may be located between the light source 5 and the solid-state element 4.

The microwave field-transmitting antenna in the present embodiment is preferably a transparent antenna capable of penetrating the light including the first wavelength. Such a transparent antenna includes, for example, a transparent substrate and a metal layer formed from thin metal wires. This results in an antenna including both a light-opaque conductive portion formed from thin metal wires and a light transmitting window portion. The material of the thin metal wires is not particularly limited as long as it has excellent conductivity, and examples thereof may include metals such as gold, silver, copper, iron, nickel, and chromium; and alloys.

The pattern shape of the metal layer of the transparent antenna is not particularly limited, and it may be, for example, a stripe shape, a mesh shape, or a random mesh shape, and from the viewpoint of transparency, the aperture ratio is preferably 80% or more. The aperture ratio is the ratio of the area of the light transmitting window portion with respect to the total area (the total area of the light-opaque conductive portion formed from thin metal wires and the light transmitting window portion).

The solid-state quantum sensor module in the present embodiment may include a microwave field control circuit. The microwave field control circuit is similar to the contents in the first embodiment.

### 3. Light source

The solid-state quantum sensor module in the present embodiment includes a light source configured to emit light including the first wavelength that excites the color center in the solid-state element 4 from a ground state to an excited state. As shown in FIGS. 15, in the present embodiment, the light source 5 is disposed at a location capable of emitting the light including the first wavelength toward the light guide plate 6 and that faces the microwave field-transmitting antenna 3 via the light guide plate 6. That is, in the normal direction D_{N}, the light guide plate 6 is located between the light source 5 and the microwave field-transmitting antenna 3. The other features of the light source are similar to the contents in the first embodiment.

### 4. Light guide plate

The solid-state quantum sensor module in the present embodiment is provided with a light guide plate configured to guide the light including the first wavelength emitted from the light source to the solid-state element. In the present embodiment, the light guide plate is required to guide light to the solid-state element located above, and is therefore preferably a diffuser plate. Also, in the present embodiment, the light guide plate 6 may include a concave portion in which the light source 5 can be disposed, as shown in FIG. 15(c). The other features of the diffuser plate are similar to the contents describing about the diffuser plate in the first embodiment.

### 5. Light detector

The solid-state quantum sensor module in the present embodiment is provided with a light detector located on the first main surface side of the substrate and detects photoluminescence including the second wavelength emitted from the solid-state element. The other features of the light detector are similar to the contents in the first embodiment.

### 6. Substrate

The solid-state quantum sensor module in the present embodiment includes a substrate. The substrate is a member configured to support components such as the light source, light detector, solid-state element, light guide plate, and microwave field-transmitting antenna described above. The substrate is similar to the contents describing about the substrate in the first embodiment.

### 7. Others

### (1) Reflective layer

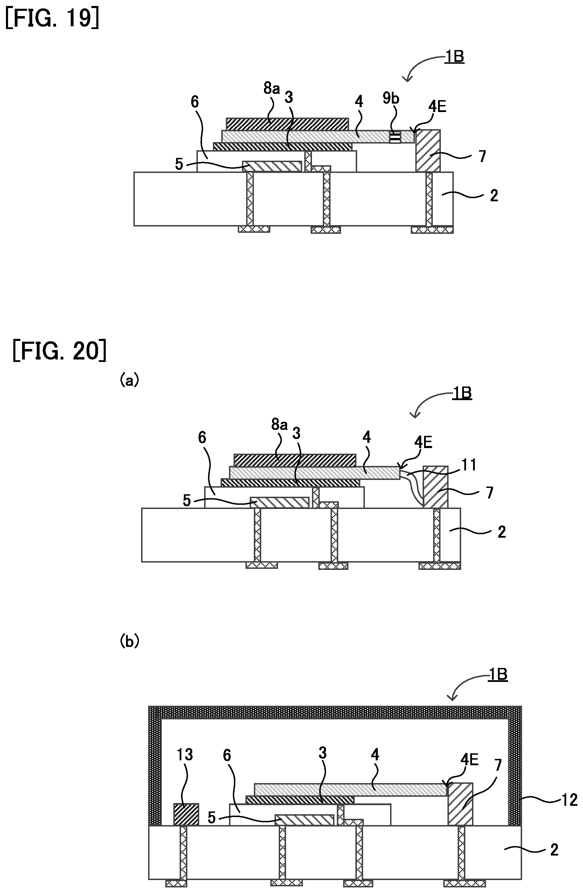

FIG. 19 is a schematic cross-sectional view exemplifying a solid-state quantum sensor module in the present embodiment. As shown in FIG. 19, the solid-state quantum sensor module 1B in the present embodiment preferably includes a first reflective layer 8a, configured to reflect the light including the first wavelength, on the surface of the solid-state element 4 that is opposite to the surface on the light guide plate 6 side. By providing such a reflective layer, the light including the first wavelength can be suppressed from leaking out from the solid-state element. The other features of the reflective layer are similar to contents describing about the reflective layer in the first embodiment.

### (2) Second light wavelength selective filter

As shown in FIG. 19, the solid-state quantum sensor module 1B in the present embodiment is preferably provided with a second light wavelength selective filter 9b, that selectively transmits the light including the second wavelength, in the solid-state element 4. The second light wavelength selective filter 9b may be located between the solid-state element 4 and the light detector 7.

The second light wavelength selective filter is not particularly limited as long as it selectively transmits the light of the second wavelength, and one similar to the second light wavelength selective filter described in the first embodiment can be used.

### (3) Photonic wire bonding

FIG. 20(a) is a schematic cross-sectional view exemplifying a solid-state quantum sensor module in the present embodiment. As shown in FIG. 20(a), in the present embodiment, the light detector 7 and the solid-state element 4 may be connected by a polymer waveguide 11 (photonic wire bonding, PWB). As the polymer waveguide, those similar to the first embodiment can be used.

### (4) Light shielding wall and heater element

FIG. 20(b) is a schematic cross-sectional view exemplifying a solid-state quantum sensor module in the present embodiment. As shown in FIG. 20(b), the solid-state quantum sensor module 1B preferably includes a light shielding wall 12 configured to shield extraneous light. As shown in FIG. 20(b), the solid-state quantum sensor module 1B in the present embodiment preferably includes a heater element 13 at a location surrounded by the light shielding wall 12 and substrate 2. As the light shielding wall and heater element, those similar to the first embodiment can be used.

### (5) Others

The solid-state quantum sensor module in the present embodiment may include other components such as a reference light detector and a permanent magnet. As the reference light detector and permanent magnet, those similar to the first embodiment can be used.

### A-3. Third embodiment

The solid-state quantum sensor module in the present embodiment is an aspect wherein a sensor element structure including a solid-state element is included instead of the solid-state element in the first embodiment and the second embodiment described above.

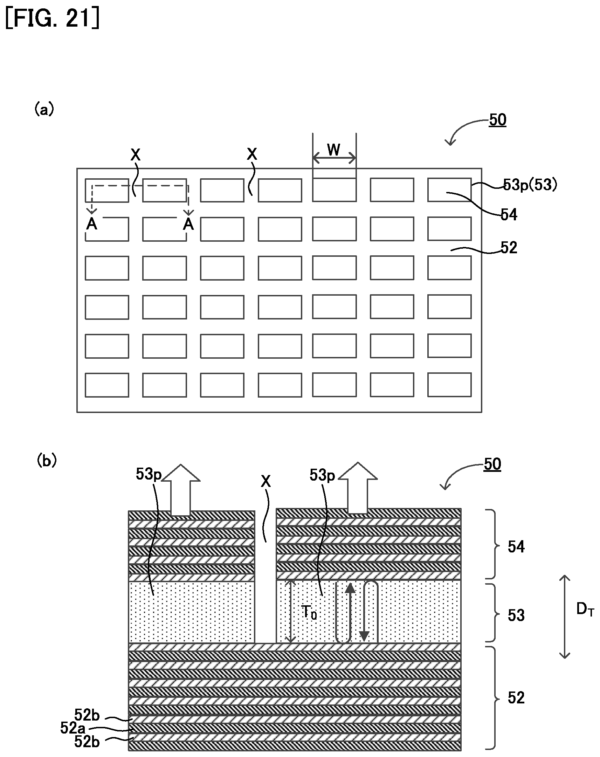

FIG. 21(a) is a schematic top view exemplifying a sensor element structure in the present embodiment, and FIG. 21(b) is an A-A line schematic cross-sectional view of FIG. 21(a). As shown in FIG. 21(a) and FIG. 21(b), the sensor element structure 50 include a first optical functional layer 52, a solid-state element 53 including a color center, and a second optical functional layer 54, in this order in the thickness direction D_{T}. The sensor element structure 50 is disposed so that the first optical functional layer 52 is on the substrate 2 side. The thickness direction D_{T} of the sensor element structure 50 usually corresponds to the normal direction D_{N} of the first main surface S1 of the substrate 2.

The solid-state element 53 excites the color center from the ground state to an excited state by excitation light including the light of the first wavelength, and emits photoluminescence including the light of the second wavelength. The first optical functional layer 52 reflects light of the second wavelength emitted from the solid-state element 53, and the second optical functional layer 54 transmits and reflects the light of the second wavelength. Further, in the present disclosure, the solid-state element 53 includes a plurality of element portions 53p isolated from each other by a groove X extending in the thickness direction D_{T}. Hereinafter, the structure of each element portion 53p of the solid-state element 53 in the present embodiment is also referred to as a second photonic cavity structure.

With the sensor element structure in the present disclosure, since the solid-state element includes a predetermined second photonic cavity structure, the photoluminescence including the light of the second wavelength emitted from the solid-state element can be efficiently progressed to the second optical functional layer side. Also, by positioning the solid-state element between the first optical functional layer that reflects light of the second wavelength and the second optical functional layer that transmits and reflects the light of the second wavelength, the light of the second wavelength can be resonated and amplified between the first optical functional layer and the second optical functional layer, and can be made easier to be emitted from the second optical functional layer. Therefore, the sensor element structure can improve the intensity of the emitted photoluminescence.

Therefore, according to the solid-state quantum sensor module in the present disclosure, since the sensor element structure described above is included, a solid-state quantum sensor module capable of highly sensitive sensing can be obtained. Hereinafter, an aspect including the sensor element structure described above instead of the solid-state element in the solid-state quantum sensor module in the first embodiment is detailed as a first aspect; and an aspect including the sensor element structure described above instead of the solid-state element in the solid-state quantum sensor module in the second embodiment is detailed as a second aspect.

### A-3-1. First aspect

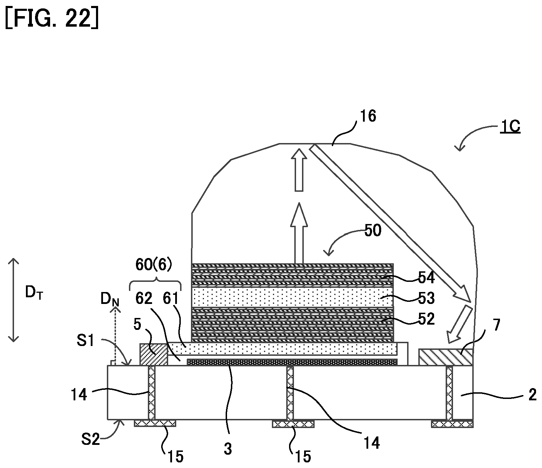

FIG. 22 is a schematic cross-sectional view exemplifying a solid-state quantum sensor module in the first aspect of third embodiment of the present disclosure. Incidentally, in FIG. 22 and in a schematic cross-sectional view of a solid-state quantum sensor module to be described later, the groove X of the sensor element structure 50 is omitted. The solid-state quantum sensor module 1C in the present disclosure comprises a substrate 2 including a first main surface S1 and a second main surface S2 located on an opposite side of the first main surface S1; a sensor element structure 50 including a solid-state element 53, located on a first main surface S1 side of the substrate 2; a light guide plate 6 located between the substrate 2 and the sensor element structure 50; a microwave field-transmitting antenna 3; a light source 5 located on the first main surface S1 side of the substrate 2 and emits excitation light including the first wavelength that excites the color center in the solid-state element 53 from a ground state to an excited state, towards the light guide plate 6; and a light detector 7 located on the first main surface S1 side of the substrate 2 and detects photoluminescence including the light of the second wavelength.

Also, as similar to the first embodiment, when viewed along a normal direction D_{N} of the first main surface S1 of the substrate 2, the solid-state element 53 overlaps with the microwave field-transmitting antenna 3. Also, when viewed along the normal direction D_{N} of the first main surface S1 of the substrate 2, the light detector 7 does not overlap with the microwave field-transmitting antenna 3. Further, in the present aspect, when viewed along the normal direction D_{N} of the first main surface S1 of the substrate 2, the light source 5 does not overlap with the microwave field-transmitting antenna 3.

Each constitution of the solid-state quantum sensor module in the present aspect is hereinafter described in detail.

### 1. Sensor element structure

As shown in FIG. 22, in the solid-state quantum sensor module 1C in the present aspect, the sensor element structure 50 is disposed so that the first optical functional layer 52 is on the substrate 2 side. The sensor element structure 50 is located on the first main surface S1 side of the substrate 2, and it is located on the surface of the light guide plate 6 that is opposite side to the substrate 2 side. Also, in the normal direction D_{N}, the sensor element structure 50 is preferably located on the surface of the microwave field-transmitting antenna substrate 3 that is opposite to the substrate 2 side. As shown in FIG. 22, when viewed along the normal direction D_{N}, at least a part of the sensor element structure 50 preferably overlaps with the light guide plate 6. Further, when viewed along a normal direction D_{N}, the sensor element structure 50 may be at a position at which at least the solid-state element 53 overlaps, or at a position at which the whole thereof overlaps with the microwave field-transmitting antenna 3.

### (1) Solid-state element

Since the type of the solid-state element is similar to the type of the solid-state element in the first embodiment described above, the description herein is omitted.

In the present disclosure, by positioning the solid-state element 53 between the first optical functional layer 52 and the second optical functional layer 54 in the thickness direction D_{T}, the light can be resonated and amplified between the first optical functional layer and the second optical functional layer.

The thickness T₀ (optical path length) of such the solid-state element is preferably, for example, n1-fold ("n1" is an integer) of (the second wavelength λ₂/2). Incidentally, the optical path length is a value obtained by multiplying the physical distance by the refractive index of the medium. This is because the resonance of the light of the second wavelength tends to occur. The "n1" is 1 or more, and is appropriately set by, for example, simulation based on the physical properties such as the dielectric constant and transmittance of the second photonic cavity material (that is, the solid-state element material).

In the present disclosure, the solid-state element includes a plurality of element portions 53p isolated from each other by a groove X extending in the thickness direction D_{T}. By including such a plurality of element portions 53p, photoluminescence including the light of the second wavelength can be efficiently progressed to the second optical functional layer side, due to the refractive index difference with respect to the groove X (air).

In the present disclosure, the shape and installing location of the groove are not particularly limited, as long as the solid-state element can be isolated into a plurality of element portions. As shown in FIG. 21(b), the groove X may be formed, for example, from the second optical functional layer 54 side surface to the interface between the solid-state element 53 and the first optical functional layer 52. Meanwhile, the groove X may also be formed in the first optical functional layer. As shown in FIG. 21(a), the groove X is preferably in a lattice form in a plan view.

The planary shape of the element portion 53p is not particularly limited, and examples may include a rectangular shape, a polygonal shape and a circular shape. Also, the size of the element portion in a plan view is, for example, 50 nm or more, and preferably 100 nm or more. Meanwhile, the size of the element portion is, for example, 100 µm or less, and preferably 10 µm or less. The size of the element portion is the longest length in the element portion, and in the case of FIG. 21 (a), it corresponds to "W".

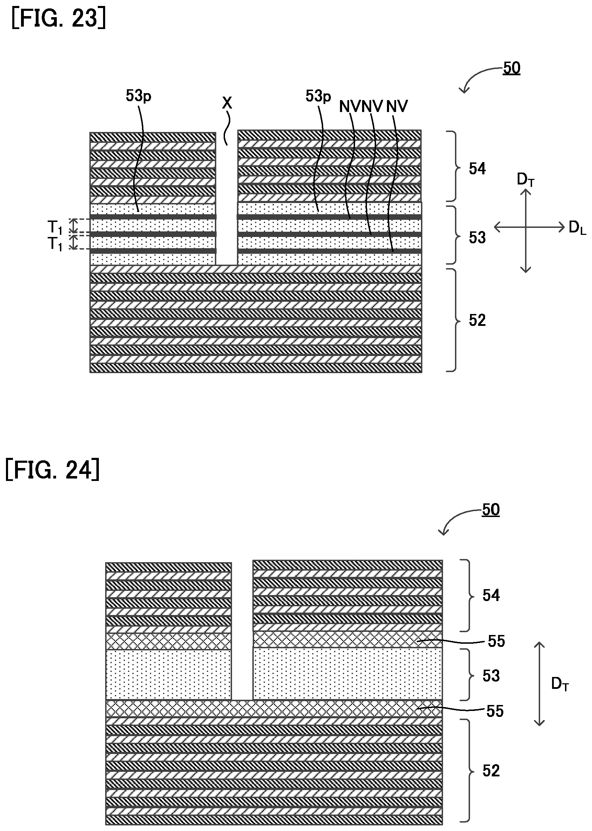

FIG.23 is a schematic cross-sectional view exemplifying the sensor element structure in the present disclosure. As shown in FIG. 23, the element portion 53p preferably includes a plurality of the color center layers (NV in FIG. 23) extending along the direction D_{L} perpendicular to the thickness direction D_{T} and located side by side at a predetermined distance T₁ along the thickness direction D_{T}.

By including the plurality of the color center layers located side by side at a predetermined distance, the light of the second wavelength can be suppressed from offsetting with each other, and the light emitting amount can be amplified. The predetermined distance T₁ (optical path length) is preferably n2-fold ("n2" is a positive integer) of the second wavelength λ₂. The above "n2" is preferably 0.6 or more and 1.4 or less, and more preferably 0.8 or more and 1.2 or less.

The number of the color center layers included in each element portion 53p is, for example, 2 or more, may be 5 or more, and may be 10 or more. Meanwhile, the number is, for example, 1000 or less, may be 500 or less, and may be 100 or less.

As for the method for disposing the color centers at the predetermined distance, conventional commonly known ones can be used. To artificially form an NV center in a diamond, for example, a vacancy is introduced into the diamond, at the same time as a nitrogen atom. As a method for introducing a nitrogen atom, the following method is used: after preparing a diamond, an ion implantation method is used. In the ion implantation method, nitrogen atoms can be introduced into the diamond in the desired arrangement and the desired amount by improving the focusing technique of the ion beam and the control of the ion amount. In the ion implantation method, ions accelerated to several tens kV to several thousand kV are usually irradiated, and therefore vacancies are also introduced at the same time as nitrogen. Alternatively, a method is used in which electron beams are irradiated, in a controlled manner, to a diamond pre-doped with nitrogen by introducing nitrogen during diamond synthesis.

### (2) First optical functional layer

The first optical functional layer in the present aspect is a layer configured to reflect the light of the second wavelength. Also, the first optical functional layer preferably transmits the light of the first wavelength that excites the color center in the solid-state element from a ground state to an excited state.

The first optical functional layer preferably has a reflectance, with respect to the light of the second wavelength, of 70% or more, and more preferably 90% or more, for the light of the second wavelength. Meanwhile, the reflectance, with respect to the light of the second wavelength, is, for example, 99.9% or less, and may be 95% or less. Also, the transmittance, with respect to the light of the first wavelength, is preferably 50% or more, and more preferably 70% or more.

Such a first optical functional layer preferably constitutes a distributed Bragg reflector (DBR) with a multilayer film in which a plurality types of materials having different refractive indexes are alternately stacked. As shown in FIG. 21(b), the first optical function layer 52 is preferably a multilayer film in which a low refractive index layer 52a and a high refractive index layer 52b are alternately stacked.

Examples of the layers included in the multilayer film may include a combination of any one of materials such as SiO₂, TiO₂, ZrO₂, MgO, Ta₂O₅, Al₂O₃, MgF₂, and CaF₂. Among these, it is preferable to include a SiO₂ layer as the low refractive index layer and a TiO₂ layer as the high refractive index layer. The reflectance can be controlled by adjusting the type and number of layers (number of pairs of a low refractive index layer and a high refractive index layer) included in the multilayer film. The thickness (optical path length) of each layer included in the multilayer film is preferably the second wavelength λ₂/4.

### (3) Second optical functional layer

The second optical functional layer in the present aspect is a layer that transmits and reflects light of the second wavelength λ₂. Examples of such a second optical functional layer may include the type similar to the multilayer film of the first optical functional layer described above. The number of layers (number of pairs of a low refractive index layer and a high refractive index layer) included in the multilayer film of the second optical functional layer is preferably less than the number of layers (number of pairs of a low refractive index layer and a high refractive index layer) included in the multilayer film of the first optical functional layer. This is because the reflectance of the second optical functional layer can be made less than the reflectance of the first optical functional layer.

The second optical functional layer preferably has a reflectance, with respect to the light of the second wavelength, of 10% or more, and more preferably 30% or more. Meanwhile, the reflectance is preferably, for example, 50% or less, and more preferably 40% or less. Also, the transmittance, with respect to the light of the second wavelength, is preferably 50% or more, and more preferably 70% or more. Meanwhile, the transmittance is preferably, for example, 90% or less, and more preferably 80% or less.

### (4) Thickness adjusting layer

As described above, the thickness T₀ (optical path length) of the solid-state element in the present aspect is preferably n1-fold ("n1" is an integer) of (the second wavelength λ₂/2). Meanwhile, when the thickness of the solid-state element is less than the thickness described above, as shown in FIG. 24, it is preferable that the sensor element structure 50 in the present disclosure includes a thickness adjusting layer 55 at least one location of between the solid-state element 53 and the first optical functional layer 52, and between the solid-state element 53 and the second optical functional layer 54.

It is preferable that the thickness (optical path length) of the thickness adjusting layer 55 is such that the total thickness together with the thickness of the solid-state element is n1-fold ("n1" is an integer) of (the second wavelength λ₂/2).

The refractive index of the thickness adjusting layer is preferably close to the refractive index of the solid-state element. The ratio (n₅/n₀) of the refractive index n₅ of the thickness adjusting layer with respect to the refractive index n₀ of the solid-state element is, for example, 1.5 or less, and preferably 1.3 or less. Meanwhile, the ratio is, for example, 0.65 or more, and may be 0.75 or more.

The thickness adjusting layer having the above refractive index is preferably, for example, a layer including, for example, TiO₂, In₂O₃, SnO₂, Ta₂O₅, Nb₂O₅, Ti₃O₅ and TiO.

### (5) Method for producing

The method for producing a sensor element structure is not particularly limited, and includes, for example, a solid-state element preparing step of preparing the solid-state element; a disposing step of disposing the first optical adjusting layer on one surface of the solid-state element and disposing the second optical adjusting layer on the other surface; and a groove forming step of forming a groove from the second optical adjusting layer side to at least the interface between the solid-state element and the first optical adjusting layer.

The solid-state element preparing step may be carried out by conventionally known methods.

Examples of the disposing step may include a method stacking and disposing the first optical adjusting layer and the second optical adjusting layer on the solid-state element by sputtering film formation. Either one of the disposition of the first optical adjusting layer and the disposition of the second optical adjusting layer may be carried out first.

The groove forming step can be carried out by conventionally known methods, and for example, the grooves can be formed in the second optical adjusting layer and the solid-state element by dry etching such as reactive ion etching.

### 2. Light source

The light source is similar to the light source in the first embodiment described above.

### 3. Microwave field-transmitting antenna

The solid-state quantum sensor module in the present aspect includes a microwave field-transmitting antenna to apply a microwave field to the solid-state element. As shown in FIG. 22, the microwave field-transmitting antenna 3 is located on the substrate 2 side than the sensor element structure 50.

Other features of the microwave field-transmitting antenna are similar to the contents described in the first embodiment.

### 4. Light guide plate

The solid-state quantum sensor module in the present aspect is provided with a light guide plate located between the substrate and the sensor element structure, and configured to guide excitation light, including the light of the first wavelength emitted from the light source, to the solid-state element. In the present aspect, the light guide plate may be an optical waveguide that propagates light in the surface direction of the light guide plate, and may be a diffuser plate that diffuses light in the vertical direction.

The optical waveguide and the diffuser plate are similar to the contents described in the first embodiment.

The light guide plate in the present aspect may have both functions of the optical waveguide and diffuser plate described above. For example, when viewed along the normal direction D_{N}, the light including the first wavelength is propagated by an optical waveguide from the end portion on the light source side to the end portion of the sensor element structure, and a diffuser plate is used in the region overlapping with the sensor element structure, making it easier to introduce light into the sensor element structure located above.

### 5. Light detector

As shown in FIG. 22, the solid-state quantum sensor module in the present aspect is provided with a light detector 7 located on the first main surface S1 side of the substrate 2 and detects photoluminescence including the light of the second wavelength emitted from the sensor element structure 50. The photoluminescence may include, as the second wavelength, one or more wavelengths (such as a wavelength of approximately 637 nm) of light corresponding to the emission wavelength of the NV center.

As shown in FIG. 22, when viewed along the normal direction D_{N}, the light detector 7 is disposed at a location that does not overlap with the microwave field-transmitting antenna 3. The light detector 7 preferably has a detection surface at least on its upper surface.

### 6. Reflective mirror

As shown in FIG. 22, the solid-state quantum sensor module 1C in the present aspect is preferably provided with a reflective mirror 16 that reflects photoluminescence emitted from the sensor element structure 50, and progresses toward the light detector 7. Examples of the reflective mirror may include a member formed from a metal or a non-metal; and a member including a reflective layer formed from a metal or a non-metal. The metal or non-metal material is preferably a non-magnetic material, and for example, aluminum (Al), tin (Sn), silver (Ag), gold (Au), titanium (Ti), chromium (Cr), or alloys thereof, or oxides, nitrides, or oxynitrides thereof can be used.

The installing position of the reflective mirror is not particularly limited as long as it is at least capable of reflecting the photoluminescence emitted from the sensor element structure and directing it toward the detector. Since photoluminescence is emitted upward from the sensor element structure, the reflective mirror is preferably disposed at least above the sensor element structure. Also, as shown in FIG. 22, it is preferably disposed on the first surface S1 of the substrate 2 so as to cover the sensor element structure 50.

The reflective mirror may be capable of shielding light from the outside. In other words, the reflective mirror may have the functions as the light shielding wall described later. In this case, the solid-state quantum sensor module in the present aspect may include a heater element described later at a location surrounded by the reflective mirror and substrate.

### 7. Substrate

The substrate is similar to the contents described in the first embodiment.

### 8. Others

### (1) Reflective layer

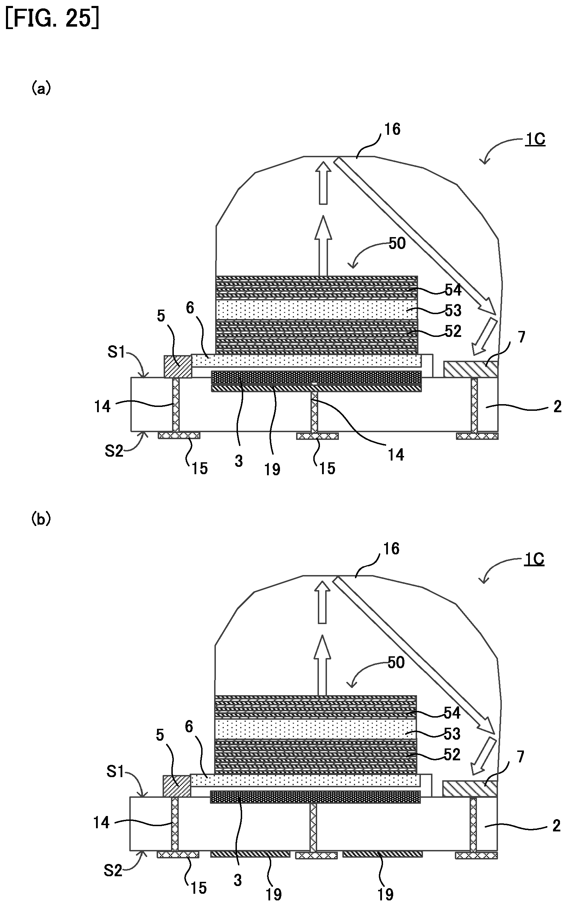

FIG. 25(a) and FIG. 25(b) are schematic cross-sectional views exemplifying a solid-state quantum sensor module in the present aspect. As shown in FIG. 25(a), the solid-state quantum sensor module 1C in the present aspect is preferably provided with a reflective layer 19, that reflects light of the first wavelength, on the surface of the microwave field-transmitting antenna 3 that is opposite side to the light guide plate 6. In particular, when the light guide plate 6 is the diffuser plate described above, the reflective layer 19 is preferably disposed. When the substrate 2 is a glass substrate, the reflective layer 19 may be located on the second main surface S2 side of the substrate 2, as shown in FIG. 25(b). By disposing such a reflective layer, the light of the first wavelength can be suppressed from being leaked out without being introduced into the solid-state element.

The reflective layer is not particularly limited as long as it is a layer capable of reflecting the light including the first wavelength, and examples thereof may include a metal vapor deposition film. The thickness of the reflective layer is not particularly limited as long as it is a thickness capable of obtaining a desired reflectance with respect to the light including the first wavelength, and is appropriately set.

### (2) Wavelength selective filter

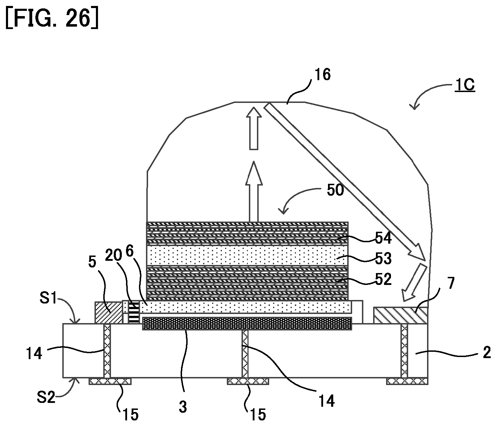

FIG. 26 is a schematic cross-sectional view exemplifying a solid-state quantum sensor module in the present disclosure. As shown in FIG. 26, the solid-state quantum sensor module 1C in the present aspect is preferably provided with a wavelength selective filter 20, that selectively transmits the light of the first wavelength, in the light guide plate 6. The wavelength selective filter may be located between the light guide plate 6 and the light source 5.

The wavelength selective filter is not particularly limited as long as it selectively transmits the light of the first wavelength, and known filters can be used.

### (3) Shielding portion

The solid-state quantum sensor module in the present aspect preferably includes a shielding portion that shields microwaves emitted from the microwave field-transmitting antenna. The shielding portion is preferably located so that it surrounds the microwave field-transmitting antenna. The shielding portion is preferably located in at least one of the substrate and the light guide plate. By providing the shielding portion, it is possible to suppress the electronic components such as the light detector and the light source from being directly exposed to the microwave noise emitted from the microwave field-transmitting antenna. As the material of the shielding portion, the material of the shielding portion in the first embodiment can be used.

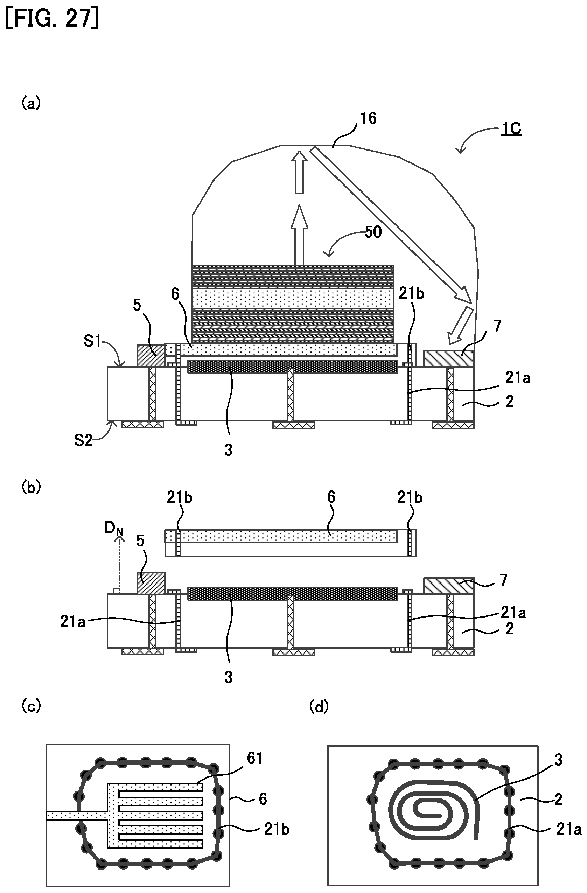

FIG. 27(a) is a schematic cross-sectional view exemplifying a solid-state quantum sensor module in the present aspect. FIG. 27(b) is an exploded view of the solid-state quantum sensor module shown in FIG. 27(a). FIG. 27(c) is a top view of the light guide plate 6 shown in FIG. 27(b), and FIG. 27(d) is a top view of the substrate 2 and microwave field-transmitting antenna 3 shown in FIG. 27(b) when viewed along the normal direction D_{N}.

The solid-state quantum sensor module shown in FIG. 27(a) to FIG. 27(d) includes the first shielding portion 21a in the substrate 2 and includes the second shielding portion 21b in light guide plate 6. In this way, the shielding effect can be improved by providing the shielding portions both in the substrate and in the light guide plate.

### (4) Other members

The solid-state quantum sensor module preferably includes any one or more of a light shielding wall configured to shield extraneous light, a reference light detector configured to detect the light including the first wavelength, a heater element, and a permanent magnet. The light shielding wall, reference light detector, heater element, and permanent magnet are similar to the contents described in the first embodiment. Also, the solid-state quantum sensor module in the present aspect may include various electronic components such as an IC (integrated circuit), for example, an amplifier and an A/D converter.

### A-3-2. Second aspect

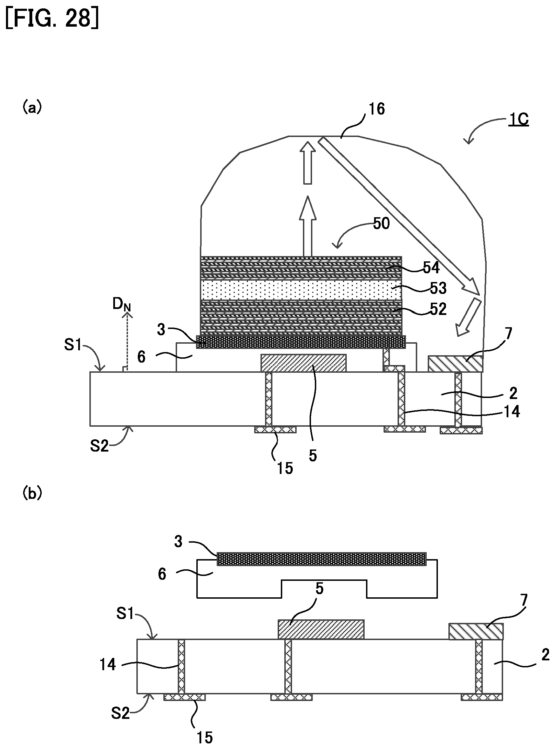

FIGS. 28 are schematic cross-sectional views showing the second aspect of the solid-state quantum sensor module in the third embodiment in the present disclosure. The solid-state quantum sensor module 1C in the present disclosure comprises a substrate 2 including a first main surface S1 and a second main surface S2 located on an opposite side of the first main surface S1; a sensor element structure 50 including a solid-state element 53, located on a first main surface S1 side of the substrate 2; a light guide plate 6 located between the substrate 2 and the sensor element structure 50; a microwave field-transmitting antenna 3; a light source 5 located on the first main surface S1 side of the substrate 2 and emits excitation light including the first wavelength that excites the color center in the solid-state element 53 from a ground state to an excited state, towards the light guide plate 6; and a light detector 7 located on the first main surface S1 side of the substrate 2 and detects photoluminescence including the light of a second wavelength.

Also, as similar to the second embodiment, when viewed along the normal direction D_{N} of the first main surface S1 of the substrate 2, the solid-state element 53 overlaps with the microwave field-transmitting antenna 3. Also, when viewed along the normal direction D_{N} of the first main surface S1 of the substrate 2, the light detector 7 does not overlap with the microwave field-transmitting antenna 3. Further, as similar to the second embodiment, the microwave field-transmitting antenna 3 is a transparent antenna capable of penetrating the light including the first wavelength, and in the normal direction D_{N}, the light guide plate 6 is located between the light source 5 and the microwave field-transmitting antenna 3.

According to the present aspect, since the light source, light guide plate, and microwave field-transmitting antenna are disposed on top of each other, the solid-state quantum sensor module can be further downsized. Further, the light from the light source can be efficiently introduced into the sensor element structure. Each constitution of the solid-state quantum sensor module in the present aspect is hereinafter described in detail.

Each constitution of the solid-state quantum sensor module in the present aspect is hereinafter described in detail.

### 1. Sensor element structure

As shown in FIGS. 28, the sensor element structure 50 in the present aspect is located on the first main surface S1 side of the substrate 2, and it is located on the surface of the light guide plate 6 that is opposite side to the substrate 2 side. Also, in the normal direction D_{N}, the sensor element structure 50 is disposed on the surface of the microwave field-transmitting antenna 3 that is opposite to the substrate 2 side. Also, in the normal direction D_{N}, the sensor element structure 50 is located on the surface of the light source 5 that is opposite side to the substrate 2 side. In the normal direction D_{N}, the solid-state quantum sensor module 1C in the present aspect preferably includes the substrate 2, light source 5, light guide plate 6, microwave field-transmitting antenna 3 and the sensor element structure 50 in this order.

Since the features of the sensor element structure in the present aspect other than those described above are similar to the sensor element structure in the first aspect described above, the description herein is omitted.

### 2. Microwave field-transmitting antenna

The solid-state quantum sensor module in the present aspect includes a microwave field-transmitting antenna to apply a microwave field to the solid-state element. As shown in FIG. 28, the microwave field-transmitting antenna 3 in the present aspect is located on the substrate 2 side than the sensor element structure 50. In the present aspect, the microwave field-transmitting antenna 3 may be located between the light source 5 and the sensor element structure 50.

The microwave field-transmitting antenna in the present aspect is preferably a transparent antenna capable of penetrating the light of the first wavelength. Such a transparent antenna includes, for example, a transparent substrate and a metal layer formed from thin metal wires. This results in an antenna including both a light-opaque conductive portion formed from thin metal wires and a light transmitting window portion. The material and pattern shape of the thin metal wire are similar to the contents described in the second embodiment.

The solid-state quantum sensor module in the present aspect may include a microwave field control circuit. The microwave field control circuit is similar to the contents in the first embodiment.

### 3. Light source

The solid-state quantum sensor module in the present aspect includes a light source configured to emit the excitation light including the light of the first wavelength that excites the color center in the solid-state element from a ground state to an excited state. As shown in FIG. 28(a), in the present aspect, the light source 5 is disposed at a location that faces the microwave field-transmitting antenna 3 via the light guide plate 6. That is, in the normal direction D_{N}, the light guide plate 6 is located between the light source 5 and the microwave field-transmitting antenna 3. The other features of the light source are similar to the contents in the first embodiment.

### 4. Light guide plate

The solid-state quantum sensor module in the present aspect is provided with a light guide plate configured to guide the excitation light including the light of the first wavelength emitted from the light source to the sensor element structure. In the present aspect, the light guide plate is required to guide light to the sensor element structure located above, and is therefore preferably a diffuser plate. Also, in the present aspect, the light guide plate 6 may include a concave portion in which the light source 5 can be disposed, as shown in FIG. 28(b). The other features of the diffuser plate are similar to the contents describing about the diffuser plate in the first embodiment.

### 5. Light detector

The solid-state quantum sensor module in the present aspect is provided with a light detector located on the first main surface side of the substrate and detects photoluminescence including the light of the second wavelength. The other features of the light detector are similar to the contents in the first aspect.

### 6. Reflective mirror

As shown in FIG. 28(a), the solid-state quantum sensor module 1C in the present aspect is preferably provided with a reflective mirror 16 that reflects photoluminescence emitted from the sensor element structure 50, and progresses toward the light detector. The reflective mirror is similar to the contents describing about the substrate in the first aspect.

### 7. Substrate

The solid-state quantum sensor module in the present aspect includes a substrate. The substrate is a member configured to support the components such as the light source, light detector, sensor element structure, light guide plate, and microwave field-transmitting antenna described above. The substrate is similar to the contents describing about the substrate in the first aspect.

### 8. Others

### (1) Reflective layer

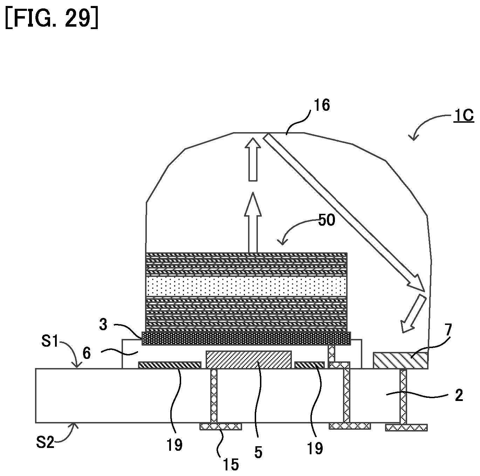

FIG. 29 is a schematic cross-sectional view exemplifying a solid-state quantum sensor module in the present aspect. As shown in FIG. 29, the solid-state quantum sensor module 1C in the present aspect is preferably provided with a reflective layer 19 that reflects the light including the first wavelength to the surface of the light guide plate 6 that is opposite side to the sensor element structure 50. By including such a reflective layer, the light including the first wavelength can be suppressed from being leaked from the light guide plate 6. The other features of the reflective layer are similar to contents describing about the reflective layer in the first aspect.

### (2) Light shielding wall and heater element

The solid-state quantum sensor module in the present aspect preferably includes a light shielding wall configured to shield extraneous light. Also, the solid-state quantum sensor module in the present embodiment preferably includes a heater element at a location surrounded by the light shielding wall and substrate. As the light shielding wall and heater element, those similar to the first aspect can be used.

### (3) Others

The solid-state quantum sensor module in the present aspect may include other components such as a reference light detector and a permanent magnet. As the reference light detector and permanent magnet, those similar to the first aspect can be used.

### B. Sensor device

The present disclosure provides a sensor device comprising the solid-state quantum sensor module described above. Since the sensor device in the present disclosure comprises the solid-state quantum sensor module described above, downsizing is possible.

### 1. Solid-state quantum sensor module

The solid-state quantum sensor module in the present disclosure is the solid-state quantum sensor module in the first embodiment, the second embodiment and the third embodiment described above.

### 2. Others

The sensor device in the present disclosure preferably includes a control portion configured to control the light source, microwave field-transmitting antenna and light detector. It may also include a data processing portion configured to process the optical measurement signals obtained by the light detector.

### 3. Use application

In the present disclosure, the sensor device is preferably a measuring device configured to measure the magnetic field. Meanwhile, by interacting the color center electron spin with a measurement object, not only the magnetic field but also various information about the measurement object can be investigated. Since the color center electron spin state varies depending on various factors such as the electric field from the measurement object, the temperature of the measurement object, and dynamic quantities such as dynamic stress (pressure) applied to the measurement object, the electric field, temperature, and dynamical quantities of the measurement object can be investigated by properly processing the detected electron spin state data after the interaction.

Incidentally, the present disclosure is not limited to the embodiments. The embodiments are exemplification, and any other variations are intended to be included in the technical scope of the present disclosure if they have substantially the same constitution as the technical idea described in the claim of the present disclosure and offer similar operation and effect thereto.

In other words, the present disclosure can provide the following inventions.
[1] A solid-state quantum sensor module comprising:
   a substrate including a first main surface and a second main surface located on an opposite side to the first main surface;
   a solid-state element, including a color center, located on a first main surface side of the substrate;
   a light guide plate located between the substrate and the solid-state element;
   a microwave field-transmitting antenna;
   a light source located on the first main surface side of the substrate and emits light including a first wavelength that excites the color center from a ground state to an excited state; and
   a light detector located on the first main surface side of the substrate and detects photoluminescence including a second wavelength emitted from the solid-state element, wherein,
   when viewed along a normal direction of the first main surface of the substrate, the solid-state element overlaps with the microwave field-transmitting antenna; and
   when viewed along the normal direction of the first main surface of the substrate, the light detector does not overlap with the microwave field-transmitting antenna.
[2] The solid-state quantum sensor module according to [1], wherein, when viewed along the normal direction of the first main surface of the substrate, the light source does not overlap with the microwave field-transmitting antenna.
[3] The solid-state quantum sensor module according to [2], wherein, in a region overlapping with the light guide plate, when viewed along the normal direction of the first main surface of the substrate, the microwave field-transmitting antenna is located on a substrate side than the light guide plate in the normal direction.
[4] The solid-state quantum sensor module according to [1], wherein the microwave field-transmitting antenna is a transparent antenna capable of penetrating the light including the first wavelength, and when viewed along the normal direction of the first main surface of the substrate, the light source overlaps with the microwave field-transmitting antenna; and
   in a region where the light source and the microwave field-transmitting antenna overlap with each other, and in the normal direction, the light guide plate is located between the light source and the microwave field-transmitting antenna.
[5] The solid-state quantum sensor module according to [4], wherein, in the region where the light source and the microwave field-transmitting antenna overlaps with each other, the solid-state quantum sensor module includes the light source, the light guide plate, the microwave field-transmitting antenna and the solid-state element in this order from a substrate side.
[6] The solid-state quantum sensor module according to any one of [1] to [5], wherein the solid-state element includes a line pattern extending in a direction toward the light detector.
[7] The solid-state quantum sensor module according to [6], wherein the solid-state element includes a pattern group including a plurality of the line patterns.
[8] The solid-state quantum sensor module according to [6] or [7], wherein the line pattern in the solid-state element includes a photonic mirror structure.
[9] The solid-state quantum sensor module according to any one of [1] to [8], wherein a light detector side end portion of the solid-state element has a curvature.
[10] The solid-state quantum sensor module according to any one of [6] to [8], wherein the line pattern in the solid-state element includes a plurality of the color centers located side by side at a predetermined distance along the direction toward the light detector.
[11] The solid-state quantum sensor module according to any one of [1] to [10], wherein the light detector and the solid-state element are connected by a photonic wire bonding.
[12] The solid-state quantum sensor module according to [7], wherein the solid-state element includes a plurality of the pattern groups.
[13] The solid-state quantum sensor module according to any one of [1] to [12], wherein the solid-state element is a diamond including an NV center.
[14] The solid-state quantum sensor module according to [3], further comprising a reflective layer located on at least one of a surface of the solid-state element located on an opposite side to the light guide plate and a surface of the microwave field-transmitting antenna located on an opposite side to the light guide plate, and reflects the light including the first wavelength.
[15] The solid-state quantum sensor module according to [4], further comprising a reflective layer located on a surface of the solid-state element located on an opposite side to the light guide plate, and reflects the light including the first wavelength.
[16] The solid-state quantum sensor module according to any one of [1] to [15], wherein the solid-state quantum sensor module includes a first light wavelength selective filter located in the light guide plate or between the light guide plate and the light source, and selectively transmits the light including the first wavelength.
[17] The solid-state quantum sensor module according to any one of [1] to [16], wherein the solid-state quantum sensor module includes a second light wavelength selective filter located in the solid-state element or between the solid-state element and the light detector, and selectively transmits the light including the second wavelength.
[18] The solid-state quantum sensor module according to any one of [1] to [17], wherein the solid-state quantum sensor module includes a sensor element structure including the solid-state element;
   the sensor element structure includes a first optical functional layer, the solid-state element and a second optical functional layer in this order from a substrate side, in a thickness direction;
   the solid-state element includes a plurality of element portions isolated from each other by a groove extending in the thickness direction;
   the first optical functional layer reflects light of the second wavelength; and
   the second optical functional layer transmits and reflects the light of the second wavelength.
[19] The solid-state quantum sensor module according to any one of [1] to [18], wherein at least one of the substrate and the light guide plate includes a shielding portion that shields microwaves emitted from the microwave field-transmitting antenna.
[20] A sensor device comprising the solid-state quantum sensor module according to any one of [1] to [19].

### Reference Signs List

1A, 1B, 1C ... solid-state quantum sensor module
2 ... substrate
3 ... microwave field-transmitting antenna
4 ... solid-state element
4p ... line pattern
5 ... light source
6 ... light guide plate
7 ... light detector
8a, 8b, 19 ... reflective layer
9a, 9b, 20 ... wavelength selective filter
10a, 10b, 21a, 21b ... shielding portion
11 ... polymer waveguide
12 ... light shielding wall
14 ... through electrode layer
15 ... conductive layer
16 ... reflective mirror
41 ... light-emitting region
42 ... connecting region
50 ... sensor element structure
52 ... first optical functional layer
52a ... low refractive index layer
52b ... high refractive index layer
53 ... solid-state element
54 ... second optical functional layer
55 ... thickness adjusting layer
60 ... optical waveguide
61 ... core layer
62 ... clad layer
B ... bus cavity
C ... pattern group
01, O2 ...air gap group

## Claims

1. A solid-state quantum sensor module comprising:
a substrate including a first main surface and a second main surface located on an opposite side to the first main surface;
a solid-state element, including a color center, located on a first main surface side of the substrate;
a light guide plate located between the substrate and the solid-state element;
a microwave field-transmitting antenna;
a light source located on the first main surface side of the substrate and emits light including a first wavelength that excites the color center from a ground state to an excited state; and
a light detector located on the first main surface side of the substrate and detects photoluminescence including a second wavelength emitted from the solid-state element, wherein,
when viewed along a normal direction of the first main surface of the substrate, the solid-state element overlaps with the microwave field-transmitting antenna; and
when viewed along the normal direction of the first main surface of the substrate, the light detector does not overlap with the microwave field-transmitting antenna.

2. The solid-state quantum sensor module according to claim 1, wherein, when viewed along the normal direction of the first main surface of the substrate, the light source does not overlap with the microwave field-transmitting antenna.

3. The solid-state quantum sensor module according to claim 2, wherein, in a region overlapping with the light guide plate, when viewed along the normal direction of the first main surface of the substrate, the microwave field-transmitting antenna is located on a substrate side than the light guide plate in the normal direction.

4. The solid-state quantum sensor module according to claim 1, wherein the microwave field-transmitting antenna is a transparent antenna capable of penetrating the light including the first wavelength, and when viewed along the normal direction of the first main surface of the substrate, the light source overlaps with the microwave field-transmitting antenna; and
in a region where the light source and the microwave field-transmitting antenna overlap with each other, and in the normal direction, the light guide plate is located between the light source and the microwave field-transmitting antenna.

5. The solid-state quantum sensor module according to claim 4, wherein, in the region where the light source and the microwave field-transmitting antenna overlaps with each other, the solid-state quantum sensor module includes the light source, the light guide plate, the microwave field-transmitting antenna and the solid-state element in this order from a substrate side.

6. The solid-state quantum sensor module according to claim 1, wherein the solid-state element includes a line pattern extending in a direction toward the light detector.

7. The solid-state quantum sensor module according to claim 6, wherein the solid-state element includes a pattern group including a plurality of the line patterns.

8. The solid-state quantum sensor module according to claim 6, wherein the line pattern in the solid-state element includes a photonic mirror structure.

9. The solid-state quantum sensor module according to claim 1, wherein a light detector side end portion of the solid-state element has a curvature.

10. The solid-state quantum sensor module according to claim 6, wherein the line pattern in the solid-state element includes a plurality of the color centers located side by side at a predetermined distance along the direction toward the light detector.

11. The solid-state quantum sensor module according to claim 1, wherein the light detector and the solid-state element are connected by a photonic wire bonding.

12. The solid-state quantum sensor module according to claim 7, wherein the solid-state element includes a plurality of the pattern groups.

13. The solid-state quantum sensor module according to claim 1, wherein the solid-state element is a diamond including an NV center.

14. The solid-state quantum sensor module according to claim 3, further comprising a reflective layer located on at least one of a surface of the solid-state element located on an opposite side to the light guide plate and a surface of the microwave field-transmitting antenna located on an opposite side to the light guide plate, and reflects the light including the first wavelength.

15. The solid-state quantum sensor module according to claim 4, further comprising a reflective layer located on a surface of the solid-state element located on an opposite side to the light guide plate, and reflects the light including the first wavelength.

16. The solid-state quantum sensor module according to claim 1, wherein the solid-state quantum sensor module includes a first light wavelength selective filter located in the light guide plate or between the light guide plate and the light source, and selectively transmits the light including the first wavelength.

17. The solid-state quantum sensor module according to claim 1, wherein the solid-state quantum sensor module includes a second light wavelength selective filter located in the solid-state element or between the solid-state element and the light detector, and selectively transmits the light including the second wavelength.

18. The solid-state quantum sensor module according to claim 1, wherein the solid-state quantum sensor module includes a sensor element structure including the solid-state element;
the sensor element structure includes a first optical functional layer, the solid-state element and a second optical functional layer in this order from a substrate side, in a thickness direction;
the solid-state element includes a plurality of element portions isolated from each other by a groove extending in the thickness direction;
the first optical functional layer reflects light of the second wavelength; and
the second optical functional layer transmits and reflects the light of the second wavelength.

19. The solid-state quantum sensor module according to claim 1, wherein at least one of the substrate and the light guide plate includes a shielding portion that shields microwaves emitted from the microwave field-transmitting antenna.

20. A sensor device comprising the solid-state quantum sensor module according to any one of claims 1 to 19.
